# EUROPEAN PATENT APPLICATION

(11) **EP 4 550 829 A1**
(43) Date of publication of application: **07.05.2025**
(21) Application number: 23929057.0
(22) Date of filing: 24.03.2023
(51) Int. Cl.: H04R 1/10

(54) **CORE MODULE AND EARPHONE**

(71) Applicant: Shenzhen Shokz Co., Ltd., Shenzhen, Guangdong 518108 (CN)
(72) Inventor: YUE, Gong, Shenzhen, Guangdong 518108 (CN); WANG, Chong, Shenzhen, Guangdong 518108 (CN); CHEN, Yunbin, Shenzhen, Guangdong 518108 (CN)
(74) Representative: Wang, Bo
(86) International application number: PCT/CN2023/083694
(87) International publication number: WO 2024/197453

(57) **Abstract**

The present disclosure relates to a core module and an earphone. The core module comprises a core shell, a speaker, and a main control circuit board. The speaker and the main control circuit board are arranged in the core shell. The speaker includes a first coil coupled to the main control circuit board, a second coil is arranged on the main control circuit board, and a winding axis direction of the second coil crosses a winding axis direction of the first coil, which is conducive to weakening mutual inductive coupling between the first coil and the second coil, thereby reducing their mutual interference. For example, such an arrangement reduces the risk of noise, such as "rustling" or "hissing" sounds generated by the speaker, caused by changes in a current of the second coil through mutual inductance. Furthermore, as the mutual inductive coupling between the first coil and second coil is reduced, the main control circuit board can be closer to the speaker, contributing to a more compact structure for the core module.

## Description

### TECHNICAL FIELD

The present disclosure relates to the technical field of electronic devices, and in particular, to a core module and an earphone.

### BACKGROUND

As electronic devices become more prevalent, they have become essential tools for socializing and entertainment in daily life, with growing demands from users. Such electronic devices as earphones and smart glasses have been commonly used, which can be paired with smartphones, computers, and other devices, to deliver an immersive auditory experience. For earphones, smart glasses, and such electronic devices, it is often challenging to balance a compact structure for the core module with low interference between components inside.

### SUMMARY

The present disclosure provides a core module, comprising a core shell, and a speaker and a main control circuit board arranged in the core shell. The speaker includes a first coil coupled to the main control circuit board, a second coil is arranged on the main control circuit board, and a winding axis direction of the second coil crosses a winding axis direction of the first coil.

In some embodiments, the main control circuit board and the speaker are stacked in the winding axis direction of the first coil.

In some embodiments, the winding axis direction of the second coil is orthogonal to the winding axis direction of the first coil.

In some embodiments, a distance between the main control circuit board and the speaker in the winding axis direction of the first coil is less than or equal to 3 mm.

In some embodiments, the core module comprises an inductor of a switching power supply, the inductor being arranged on the main control circuit board, and the inductor including the second coil; and/or
The core module comprises a transceiver coil of a communication device, the transceiver coil being arranged on the main control circuit board, and the transceiver coil including the second coil.

The present disclosure provides an earphone, comprising a hook structure and the core module. The hook structure is connected to the core shell, the core module is located at a front side of an ear in a wearing state, and at least a portion of the hook structure is located at a rear side of the ear in the wearing state.

In some embodiments, the hook structure includes an adapter shell connected to the core shell, at least a portion of the adapter shell is located at the front side of the ear in the wearing state, and the adapter shell forms an accommodation cavity. The earphone comprises an electronic element and a flexible circuit board. The electronic element is arranged in the accommodation cavity, the flexible circuit board is connected to the electronic element and extends into the core shell, which allows the electronic element to be connected to the main control circuit board through the flexible circuit board. The first coil is arranged on an extension path of the flexible circuit board and connected to the flexible circuit board, and the speaker is connected to the main control circuit board through the flexible circuit board.

In some embodiments, the adapter shell forms a through hole in communication with the accommodation cavity, the electronic element includes an electrode terminal at least partially arranged in the through hole, the electrode terminal including a charging positive terminal and a charging negative terminal that are arranged at intervals from each other, the charging positive terminal and the charging negative terminal being respectively arranged in a corresponding through hole.

In some embodiments, the core shell includes a core inner shell and a core outer shell covering the core inner shell, the core inner shell is closer to the ear than the core outer shell in the wearing state, and at least one of the core inner shell or the core outer shell is inserted and fixed to the adapter shell.

In some embodiments, the core shell includes a core inner shell and a core outer shell covering the core inner shell, the core inner shell is closer to the ear than the core outer shell in the wearing state, and at least one of the core inner shell or the core outer shell is arranged to be an integrated molded structure with the adapter shell.

Beneficial effects of the present disclosure are as follows: in the core module provoded by the present disclosure, the winding axis direction of the second coil on the main control circuit board crosses the winding axis direction of the first coil on the speaker, which is conducive to weakening mutual inductive coupling between the first coil and the second coil, thereby reducing their mutual interference. For example, such an arrangement lowers the risk of noise, such as "rustling" or "hissing" sounds generated by the speaker, caused by changes in a current of the second coil through mutual inductance. Furthermore, as the mutual inductive coupling between the first coil and second coil is reduced, the main control circuit board can be closer to the speaker, contributing to a more compact structure for the core module.

### BRIEF DESCRIPTION OF THE DRAWINGS

In order to more clearly illustrate the technical solutions in the embodiments of the present disclosure, the accompanying drawings that need to be used in the description of the embodiments will be briefly introduced in the following, and it will be obvious that the accompanying drawings in the following description are only some of the embodiments of the present disclosure, and other attachments can be obtained according to them without creative labor to a person of ordinary skill in the art.
FIG. 1 is a schematic diagram illustrating a front profile of an ear of a user according to the present disclosure;
FIG. 2 is a schematic diagram illustrating an exemplary structure of an earphone according to the present disclosure;
FIG. 3 is a schematic diagram illustrating an exemplary earphone in a wearing state according to one embodiment of the present disclosure;
FIG. 4 is a schematic diagram illustrating an exemplary structure of an earphone according to one embodiment of the present disclosure;
FIG. 5 is a schematic diagram illustrating an exemplary structure of an earphone according to one embodiment of the present disclosure;
FIG. 6 is a graph illustrating frequency response curves measured at a same listening position when a core module of an earphone is located at different positions of an ear according to one embodiment of the present disclosure;
FIG. 7 is a schematic diagram illustrating an exemplary sectional structure of an earphone shown in FIG. 2, along A1-A1 according to one embodiment of the present disclosure;
FIG. 8 is a schematic diagram illustrating an exemplary sectional structure of an earphone shown in FIG. 2, along A2-A2 according to one embodiment of the present disclosure;
FIG. 9 is a schematic diagram illustrating an exemplary structure of an earphone according to one embodiment of the present disclosure;
FIG. 10 is a schematic diagram illustrating an exemplary structure of a core shell according to one embodiment of the present disclosure;
FIG. 11 is a schematic diagram illustrating an exemplary structure of a core shell according to one embodiment of the present disclosure;
FIG. 12 is a schematic diagram illustrating an exemplary structure of a frame according to the present disclosure;
FIG. 13 is a schematic diagram illustrating an enlarged view of a structure of an earphone shown in FIG. 8 in a B1 region;
FIG. 14 is a schematic diagram illustrating an exemplary view of a structure of an earphone shown in FIG. 8 in a B2 region;
FIG. 15 is a schematic diagram illustrating an exemplary structure of a hook structure according to the present disclosure;
FIG. 16 is a schematic diagram illustrating an exemplary sectional structure of a hook structure in FIG. 15, along A3-A3 according to the present disclosure;
FIG. 17 is a schematic diagram illustrating an exemplary sectional structure of a hook structure in FIG. 15 along a direction perpendicular to A3-A3 according to the present disclosure;
FIG. 18 is a schematic diagram illustrating an exemplary disassembled structure of a hook structure in FIG. 15 according to one embodiment of the present disclosure;
FIG. 19 is a schematic diagram illustrating an exemplary structure of an earphone according to the present disclosure;
FIG. 20 is a schematic diagram illustrating an exemplary structure of an earphone according to the present disclosure;
FIG. 21 is a schematic diagram illustrating an exemplary structure of an earphone according to the present disclosure;
FIG. 22 is a schematic diagram illustrating an exemplary structure of an earphone according to the present disclosure;
FIG. 23 is a schematic diagram illustrating an exemplary structure of an earphone according to the present disclosure;
FIG. 24 is a schematic diagram illustrating an exemplary structure of a hook structure according to the present disclosure;
FIG. 25 is a schematic diagram illustrating relative positions between a first coil and a second coil according to the present disclosure; and
FIG. 26 is a schematic diagram illustrating an exemplary structure of a main control circuit board according to the present disclosure.

### DETAILED DESCRIPTION

The present disclosure is described in further detail below in conjunction with the accompanying drawings and embodiments. In particular, it is noted that the following embodiments are only used to illustrate the present disclosure, but do not limit the scope of the present disclosure. Similarly, the following embodiments are only some but not all of the embodiments of the present disclosure, and all other embodiments obtained by a person of ordinary skill in the art without making creative labor fall within the scope of protection of the present disclosure.

References to "embodiments" in the present disclosure mean that particular features, structures, or characteristics described in conjunction with embodiments may be included in at least one embodiment of the present disclosure. It is understood by those of skill in the art, both explicitly and implicitly, that the embodiments described in the present disclosure may be combined with other embodiments.

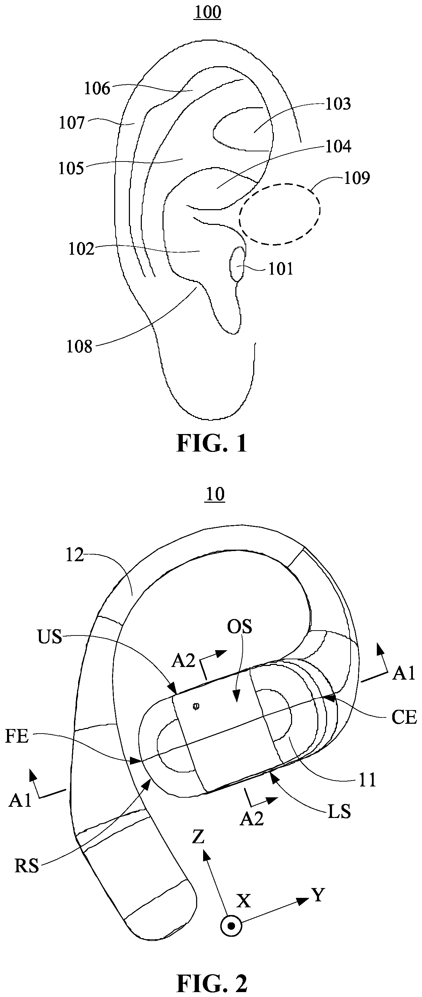

In conjunction with FIG. 1, a user's ear 100 includes physiological parts such as an external ear canal 101, a concha cavity 102, a cymba conchae 103, a triangular fossa 104, an antihelix 105, a scapha106, a helix 107, and an antitragus 108. Although the external ear canal 101 has a certain depth and extends to a tympanic membrane of the ear, for ease of description and in conjunction with FIG. 1, in the present disclosure, the external ear canal 101 refers to an entrance (i.e., the aperture) of the external ear canal 101 that is dorsal to the tympanic membrane thereof, when not otherwise specified. Furthermore, the physiological parts such as the concha cavity 102, the cymba conchae 103, the triangular fossa 104, etc., have a certain volume and a certain depth. The concha cavity 102 is in direct connection with the external ear canal 101, which means that the concha cavity 102 can be simply regarded as the aperture located at a bottom of the concha cavity 102.

Furthermore, different users may have individual differences that result in different shapes, sizes, and other dimensional differences in the ear. In order to facilitate the description and to minimize (or even eliminate) individual differences between different users, it is possible to produce a simulator with a head and its (left and right) ears based on the ANSI: S3.36, S3.25 and IEC: 60318-7 standards, e.g., GRAS 45BC KEMAR, HEAD Acoustics, B&K 4128 series or B&K 5128 series, to present a scenario in which the majority of users are wearing an earphone 10. Using GRAS KEMAR as an example, an ear simulator may be any of GRAS 45AC, GRAS 45BC, GRAS 45CC, or GRAS 43AG, etc. Using HEAD Acoustics as an example, the ear simulator may be any one of HMS II.3, HMS II.3 LN, or HMS II.3LN HEC, etc. Accordingly, in the present disclosure, the terms "a user wears an earphone," "an earphone is in a wearing state," and "in a wearing state," refer to an earphone described in the present disclosure being worn in the ear simulator. It is understandable that it is precisely because of the individual differences between different users that the earphone may differ somewhat from when it is worn by different users and when it is worn on the ear simulator, but such differences should be tolerated.

It should be noted that in the fields of medicine and anatomy, the three basic sections of the human body, Sagittal Plane, Coronal Plane, and Horizontal Plane, as well as the three basic axes, Sagittal Axis, Coronal Axis, and Vertical Axis, are be defined. The sagittal plane refers to a section perpendicular to the ground made along the anterior and posterior directions of the body, which divides the body into left and right parts; the coronal plane refers to a section perpendicular to the ground made along the left and right directions of the body, which divides the body into anterior and posterior parts; and the horizontal plane refers to a section parallel to the ground made along the up and down directions of the body, which divides the body into upper and lower parts. Correspondingly, the sagittal axis is an axis along the anterior-posterior direction of the body and perpendicular to the coronal plane, the coronal axis is an axis along the left-right direction of the body and perpendicular to the sagittal plane, and the perpendicular axis is an axis along the upper-lower direction of the body and perpendicular to the horizontal plane. Furthermore, the "front side of an ear" described herein is a concept relative to the "rear side of an ear", where the former refers to a side of the ear that is back away from the head, and the latter refers to a side of the ear that faces the head, both of which are directed to the ear of the user. Observing the ear simulator along a direction in which the coronal axis of the human body is located, a schematic diagram of a front side profile of an ear may be obtained as shown in FIG. 1.

For example, in conjunction with FIG. 2 to FIG. 5, the earphone 10 includes a core module 11 and a hook structure 12 connected to the core module 11. The core module 11 is located at a front side of the ear in a wearing state, and at least a portion of the hook structure 12 is located on a rear side of the ear in the wearing state, which allows the earphone 10 to hang on the ear in the wearing state. The core module 11 may include a connection end CE connected to the hook structure 12 and a free end FE not connected to the hook structure 12. Further, the core module 11 may be set so that an external ear canal is not blocked in the wearing state, so that the earphone 10 acts as an "open earphone". In which the core module 11 may partially block the external ear canal when the earphone 10 is worn by different users due to individual differences, but the external ear canal still remains unblocked.

In order to improve the stability of the earphone 10 in the wearing state, the earphone 10 may be used in any one of the following ways or a combination thereof. First, at least a portion of the hook structure 12 is provided as a mimetic structure that fits with at least one of the rear side of the ear and the head to increase a contact area between the hook structure 12 and the ear and/or the head, thereby increasing a resistance of the earphone 10 from falling off from the ear. Second, at least a portion of the hook structure 12 is provided as an elastic structure to have a certain amount of deformability in the wearing state to increase a positive pressure of the hook structure 12 on the ear and/or the head, thereby increasing a resistance of the earphone 10 from falling off from the ear. Third, the hook structure 12 is at least partially provided to rest against the head in the wearing state, so as to form a reaction force that presses on the ear, so as to cause the core module 11 to press on the front side of the ear, thereby increasing the resistance of the earphone 10 from falling off from the ear. Fourth, the core module 11 and the hook structure 12 are provided to hold physiological parts such as a region where an antihelix is located and a region where a concha cavity is located from the front and back of the ear in the wearing state, thereby increasing the resistance of the earphone 10 from falling off from the ear. Fifth, the core module 11 or an auxiliary structure connected thereto is provided to at least partially extend into physiological parts such as a concha cavity, a cymba conchae, a triangular fossa, a scapha, thereby increasing a resistance of the earphone 10 from falling off from the ear.

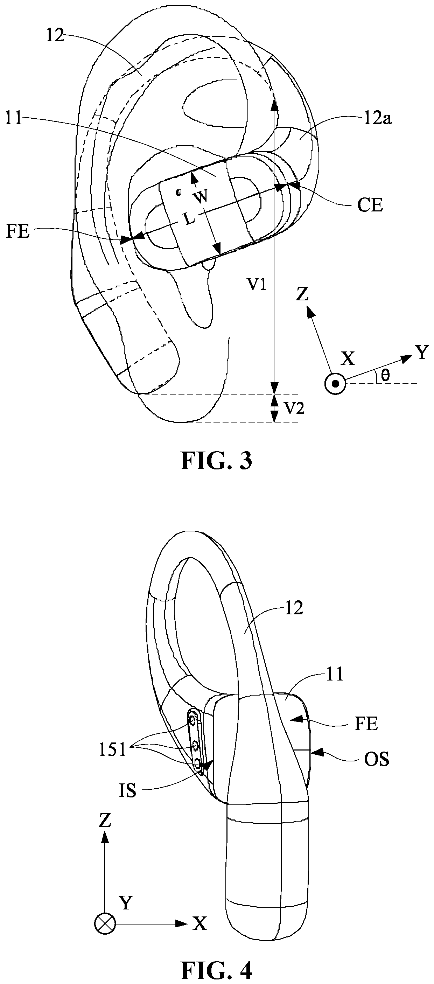

For example, in conjunction with FIG. 3, the free end FE of the core module 11 extends into the concha cavity in the wearing state. In this regard, the core module 11 and the hook structure 12 may be provided to jointly clamp the ear from the front and back of the ear corresponding to the concha cavity, thereby increasing the resistance of the earphone 10 from falling off from the ear and improving the stability of the earphone 10 in the wearing state. For example, the free end FE is pressed against the concha cavity in a thickness direction X. As another example, the free end FE is pressed against the concha cavity in a length direction Y and a width direction Z.

It should be noted that in the wearing state, the free end FE of the core module 11, in addition to being extended into the concha cavity, its orthographic projection may also fall on the antihelix, and may also fall on the left and right sides of the head and located on the front side of the ear in the sagittal axis of the human body. In other words, the hook structure 12 can support the core module 11 to be worn to wearing positions of the concha cavity, the antihelix, the front side of the ear, and so on.

For example, in conjunction with FIG. 3 and FIG. 4, in a wearing state, the core module 11 has an inner side surface IS facing an ear along a thickness direction X, an outer side surface OS back away from the ear, and a connection surface that connects the inner side surface IS and the outer side surface OS. The thickness direction X may be defined as a direction in which the core module 11 is near or away from the ear in the wearing state. Furthermore, at least a portion of the connection surface is disposed within a concha cavity in the wearing state and forms a first contact zone with a front side of the ear, and the hook structure 12 forms a second contact zone with a rear side of the ear, and the second contact zone and the first contact zone at least partially overlap in a thickness direction of the ear. In this way, not only can the core module 11 and the hook structure 12 jointly clamp the ear from the front side and the rear side of the ear, but also a clamping force formed mainly manifests compressive stress, which is conducive to improving the stability and comfort of the earphone 10 in the wearing state.

It is to be noted that in the wearing state and viewed in a direction where the coronal axis is located, the core module 11 may be set in the shape of a circle, an oval, a rounded square, a rounded rectangle, or the like. When the core module 11 is set into a shape such as a circle, an oval, etc., the connection surface refers to a curved side surface of the core module 11. When the core module 11 is set into a shape such as a rounded square, a rounded rectangle, etc. the connection surface includes a lower side surface LS, an upper side surface US, and a rear side surface RS as mentioned later. Furthermore, the core module 11 has a length direction Y and a width direction Z which are perpendicular to the thickness direction X and orthogonal to each other. The length direction Y may be defined as a direction in which the core module 11 is close to or away from the back of the user's head in the wearing state, and the width direction Z may be defined as a direction in which the core module 11 is close to or away from the top of the user's head in the wearing state. Thus, for ease of description, this embodiment is illustrated exemplarily with the core module 11 set into a rounded rectangle. A length of the core module 11 in the length direction Y may be greater than a width of the core module 11 in the width direction Z.

For example, in combination with FIG. 2, FIG. 3 and FIG. 5, in the wearing state and viewed in the direction where the coronal axis of the human body is located, the connection end CE is closer to the top of the head as compared to the free end FE, which allows the free end FE to reach into the concha cavity. Based on this, an angle between the length direction Y and a direction where the sagittal axis of the human body is located may be within a range of 15° to 60°. If the angle is too small, it is likely to result in the free end FE being unable to extend into the concha cavity, as well as a sound outlet hole 111a on the core module 11 being too far away from an external ear canal. If the angle is too large, it is equally likely to cause the free end FE to be unable to extend into the concha cavity, and the external ear canal to be blocked by the core module 11. In other words, it is set up in such a way as to allow the free end FE to extend into the concha cavity, but also to make the sound outlet hole 111a on the core module 11 have a suitable distance from the external ear canal, so that, in the case that the user can hear more of the sound waves generated by the core module 11 when the external ear canal is not blocked.

For example, in conjunction with FIG. 4, an orthographic projection of the hook structure 12 on a reference plane perpendicular to the length direction Y (e.g., an XZ plane in FIG. 4) partially overlaps with an orthographic projection of the free end FE on the reference plane. An overlapping region formed by the orthographic projection of the hook structure 12 on the reference plane and the orthographic projection of the free end FE on the reference plane is located between the inner side surface IS and the outer side surface OS in the thickness direction X. In this way, not only can the core module 11 and the hook structure 12 jointly clamp the ear from the front side and the rear side of the ear, but also the clamping force formed mainly manifests as compressive stress, which is conducive to improving the stability and comfort of the earphone 10.

Furthermore, in combination with FIG. 2, FIG. 4, FIG. 5, and FIG. 9, the hook structure 12 includes an elastic metal wire 121 connected to the core module 11 and a battery shell 123 connected to an end of the elastic metal wire 121 that is away from the core module 11. A battery 14 coupled to the core module 11 is arranged inside the battery shell 123, and an orthographic projection of the battery shell 123 on the reference plane partially overlaps with the orthographic projection of the free end FE on the reference plane. In this way, the battery shell 123 supports the ear from the rear side of the ear when the free end FE rests against the concha cavity, which is conducive to improving the stability of the earphone 10 in the wearing state. The battery shell 123 includes a cover shell 1231 connected to the elastic metal wire 121 and a battery compartment 1232 connected to the cover shell 1231, and the battery compartment 1232 and the cover shell 1231 cooperate to form a cavity structure that accommodates the battery 14.

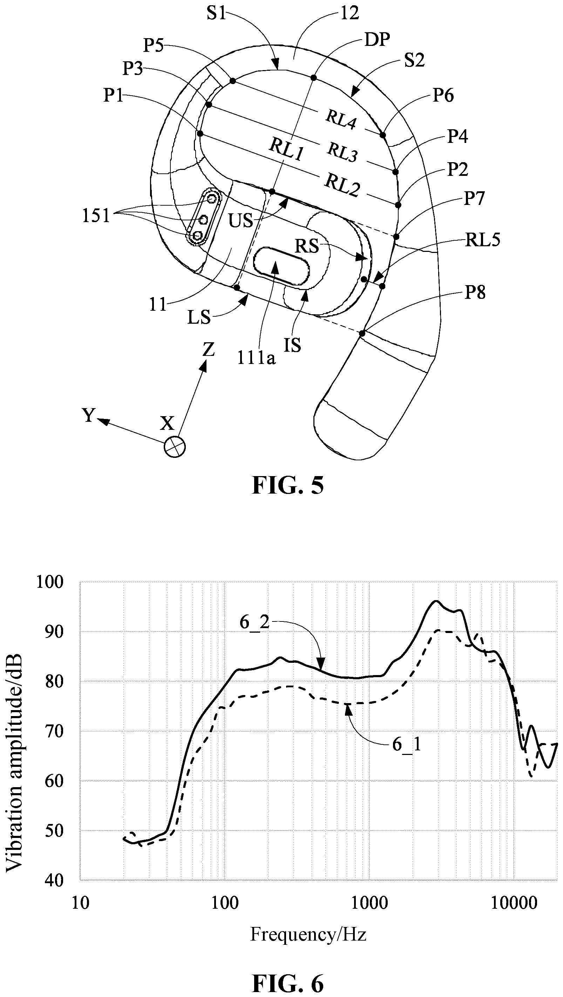

For example, in conjunction with FIG. 5, the core module 11 has the upper side surface US that is away from the external ear canal along the width direction Z and the lower side surface LS that is oriented toward the external ear canal in the wearing stat, as well as the rear side surface RS that connects the upper side surface US and the lower side surface LS. In the wearing state, the rear side surface RS is located at an end of the length direction Y that is towards the back of the head, and is at least partially located within the concha cavity. An edge of the hook structure 12 projected orthogonally on a reference plane perpendicular to the thickness direction X (e.g., a YZ plane of FIG. 5) toward the core module 11 may be divided into a first section S1 and a second section S2 in a continuous arcuate transition. A demarcation point DP between the first section S1 and the second section S2 is a point where the edge is furthest away from the upper side surface US along the width direction Z. Further, the hook structure 12 has an overall degree of curvature in the first section S1 that is greater than the overall degree of curvature of the hook structure 12 in the second section S2. In this way, the free end FE is allowed to extend into the concha cavity, but also allows the hook structure 12 to cooperate with the core module 11 to provide a suitable clamping force.

It is to be noted that the above overall degree of curvature may be used to qualitatively characterize a degree of curvature of the different sections of the hook structure 12, and a radius of curvature of each section may be a constant value or continuously vary. Thus, there is at least one point within the first section S1 having a radius of curvature that is less than a radius of curvature of any point within the second section S2. Furthermore, the overall degree of curvature can also be quantitatively characterized by an average radius of curvature, i.e., a radius of curvature of the N points on each section is first solved for and then averaged.

Further, in an extension direction of the hook structure 12, a length of the second section S2 may be greater than a length of the first section S1, so as to facilitate the clamping of the ear by the hook structure 12 together with the core module 11, as well as to increase a contact area between the hook structure 12 and the user skin, which is conducive to improving the stability of the earphone 10 in the wearing state.

In some embodiments, the earphone 10 has a first reference line RL1 parallel to the width direction Z, the first reference line RL1 begins at a point where the first reference line RL1 intersects the upper side surface US, and the first reference line RL1 ends at the demarcation point DP. A second reference line RL2, a third reference line RL3, and a fourth reference line RL4 referred to later are sequentially increasingly farther away from a starting point of the first reference line RL1 in the width direction Z. Further, a length of the first reference line RL1 may be within a range of 13 mm to 20 mm. If the length of the first reference line RL1 is too small, it is likely to result in the free end FE not being able to extend into the concha cavity, as well as the sound outlet holes 111a on the core module 11 being too far away from the external ear canal. If the length of the first reference line RL1 is too large, it is likewise likely to result in the free end FE not being able to extend into the concha cavity, as well as the external ear canal being blocked by the core module 11. In other words, it is so set up as to allow the free end FE to extend into the concha cavity, and at the same time make the sound outlet hole 111a on the core module 11 have a suitable distance from the external ear canal, so that, in the case that the external ear canal is not blocked, the user can hear more of the sound waves generated by the core module 11.

Further, the second reference line RL2, which passes 1/4 of the first reference line RL1 and is parallel to the length direction Y intersects the first section S1 and the second section S2 at a first intersection point P1 and a second intersection point P2, respectively, and a distance between the first intersection point P1 and the starting point of the first reference line RL1 and may be within a range of 9 mm to 15 mm, and a distance between the second intersection point P2 and the starting point of the first reference line RL1 may be within a range of 12 mm to 19 mm. The third reference line RL3, which passes through 1/2 of the first reference line RL1 and is parallel to the length direction Y, intersects the first section S1 and the second section S2 at a third intersection point P3 and a fourth intersection point P4, respectively, a distance between the third intersection point P3 and the starting point of the first reference line RL1 may be within a range of 11 mm to 18 mm, and a distance between the fourth intersection point P4 and the starting point of the first reference line RL1 may be within a range of 12 mm to 19 mm. The fourth reference line RL4, which passes through 3/4 of the first reference line RL1 and is parallel to the length direction Y, intersects the first section S1 and the second section S2 at a fifth intersection point P5 and a sixth intersection point P6, respectively, and a distance between the fifth intersection point P5 and the starting point of the first reference line RL may be within a range of 12 mm to 19 mm, and a distance between the sixth intersection point P6 and the starting point of the first reference line RL1 may be within a range of 12 mm to 19 mm. This is done to make the hook structure 12 better fit the ear when the free end FE extends into the concha cavity and the sound outlet hole 111a on the core module 11 is at a suitable distance from the external ear canal.

In some embodiments, the second section S2 has a fifth reference line RL5 with the shortest distance along the length direction Y between the second section S2 and the rear side surface RS, and a length of the fifth reference line RL5 may be within a range of 2 mm to 3 mm. If the length of the fifth reference line RL5 is too small, it is likely to cause the clamping force of the core module 11 and the hook structure 12 on the ear too large, leading to discomfort in wearing. If the length of the fifth reference line RL5 is too large, it is easy to cause the clamping force of the core module 11 and the hook structure 12 on the ear to be too small, leading to wearing instability. In other words, it is so set up as to take into account the stability and comfort of the earphone 10 in the wearing state.

Further, the fifth reference line RL5 is defined as follows: a point at which the fifth reference line RL5 intersects the rear side surface RS is used as a starting point of the fifth reference line RL5, and a point at which the fifth reference line RL5 intersects the second section S2 is used as an end point of the fifth reference line RL5. An orthographic projection of an intersection point between the first reference line RL1 and the upper side surface US in the length direction Y intersects the second section S2 at a seventh intersection point P7, and an orthographic projection of an intersection point between a prolongation line of the first reference line RL1 and the lower side surface LS in the length direction Y intersects the second section S2 at an eighth intersection point P8, and a distance between the seventh intersection point P7 and the starting point of the fifth reference line RL5 may be within a range of 5 mm to 9 mm, and a distance between the eighth intersection point P8 and the starting point of the fifth reference line RL5 may be within a range of 5 mm to 9 mm. This is done so as to make the hook structure 12 better fit the ear while taking into account the stability and comfort of the earphone 10 in the wearing state.

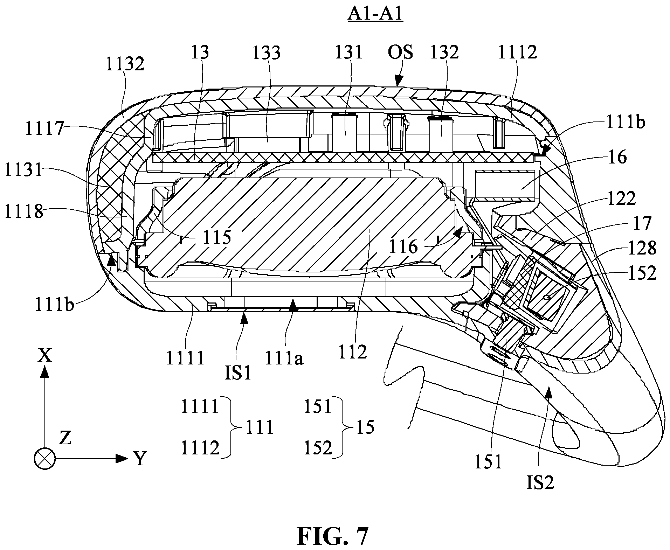

For example, in combination with FIG. 7, FIG. 8, and FIG. 5, the core module 11 includes a core shell 111 connected to the hook structure 12 and a speaker 112 arranged in the core shell 111. In the wearing state, the inner side surface (e.g., the inner side surface IS) of the core shell 111 toward the ear is provided with the sound outlet hole 111a, and sound waves generated by the speaker 112 propagate out through the sound outlet hole 111a so as to be easily transmitted into the external ear canal. Notably, the sound outlet hole 111a may also be provided on a side of the core shell 111 corresponding to the lower side surface LS, and may also be provided at a corner between the inner side surface IS and the lower side surface LS. Further, the speaker 112 may include a magnetic circuit system, a voice coil extending into the magnetic circuit system, and a vibration diaphragm connected to the voice coil. A magnetic field generated by the voice coil after being energized interacts with a magnetic field formed by the magnetic circuit system, thereby driving the vibration diaphragm to generate mechanical vibration, which in turn generates sound by propagation through a medium such as air.

Further, in conjunction with FIG. 7 to FIG. 9, the earphone 10 includes a main control circuit board 13 arranged in the core shell 111 and a battery 14 arranged at an end of the hook structure 12 away from the core module 11, the battery 14 and the speaker 112 are coupled to the main control circuit board 13, respectively, which allows the battery 14 to power the speaker 112 under the control of the main control circuit board 13. Both the battery 14 and the speaker 112 may also be arranged in the core shell 111, and the battery 14 may be closer to the connection end CE while the speaker 112 may be closer to the free end FE.

For example, in combination with FIG. 3 and FIG. 1, since the concha cavity has a certain volume and a certain depth, after the free end FE extends into the concha cavity, there is a certain distance between the inner side surface IS of the core shell 111 and the concha cavity. In other words, the core module 11 can cooperate with the concha cavity to form an auxiliary cavity that is connected to the external ear canal in the wearing state, and the sound outlet hole 111a is located at least partially within the auxiliary cavity. In this way, in the wearing state, the sound waves generated by the speaker 112 and propagated through the sound outlet hole 111a are limited by the auxiliary cavity, i.e., the auxiliary cavity can aggregate the sound waves so that the sound waves can propagate more into the external ear canal, thereby increasing a volume and sound quality of a sound heard by the user in a near field, which improves the acoustic effect of the earphone 10. Furthermore, the core module 11 can be set so as not to block the external ear canal in the wearing state, so that the auxiliary cavity can be set in a semi-open type. In this way, for the sound waves generated by the speaker 112 and propagated out through the sound outlet hole 111a, in addition to the majority of them propagating to the external ear canal, a small portion of them propagate to the earphone 10 and the exterior of the ear via a gap between the core module 11 and the ear (e.g., a portion of the concha cavity that is not covered by the core module 11), thereby forming a first sound leakage in a far field. At the same time, the core module 11 is generally provided with an acoustic hole (e.g., a pressure relief hole 111c mentioned later), sound waves propagated through the acoustic hole generally forms a second sound leakage in the far field, and a phase of the first sound leakage and a phase (proximity) of the second sound leakage are inverse to each other, so that the two can be canceled out in the far field, which is conducive to reducing sound leakage of the earphone 10 in the far field.

Further, the earphone 10 may include an adjusting mechanism connecting the core module 11 and the hook structure 12. Different users can adjust a relative position of the core module 11 on the ear through the adjusting mechanism in the wearing state, so as to make the core module 11 located at a suitable position, thereby enabling the core module 11 to form the auxiliary cavity with the concha cavity. In addition to this, the user can adjust the earphone 10 to be worn to a more stable and comfortable position through the adjusting mechanism.

For example, in connection with FIG. 6, the earphone 10 is first worn on the simulator, and then a position of the core module 11 is adjusted on an ear of the simulator, and then a frequency response curve of the earphone 10 is measured by a detector (e.g., a microphone) disposed within an external ear canal (e.g., a location of a tympanic membrane, i.e., a sound-hearing location) of the simulator, so as to simulate the effect of the sound-hearing effect of the user after wearing the earphone 10. The frequency response curve may be used to characterize a change relationship between a vibration magnitude and a frequency. A transverse coordinate of the frequency response curve denotes a frequency in Hz, and a vertical coordinate of the frequency response curve denotes a vibration magnitude in dB. In FIG. 6, a curve 6_1 represents a frequency response curve when the core module 11 in the wearing state doesn't form the auxiliary cavity with the concha cavity, and a curve 6_2 represents a frequency response curve when the core module 11 in the wearing state forms the auxiliary cavity with the concha cavity. Based on this, it can be directly concluded from a graph of a comparison of frequency response curves shown in FIG. 6 that the curve 6_2 as a whole is located above the curve 6_1, i.e., it is more conducive to improving the acoustic effect of the earphone 10 for the core module 11 in the wearing state to form the auxiliary cavity with the concha cavity than for the core module 11 in the wearing state without forming the auxiliary cavity with the concha cavity.

For example, in combination with FIG. 7, FIG. 9, and FIG. 11, the core module 11 includes a flexible insert block 1131 disposed outside the core shell 111, and a hardness of the flexible insert block 1131 is less than a hardness of the core shell 111. The core shell 111 may be a plastic component, and the flexible insert block 1131 may be made of a material such as silicone, rubber, or the like, and may be formed on a preset region of the core shell 111 by injection molding. Further, the flexible insert block 1131 may at least partially cover a region of the core shell 111 corresponding to the free end FE such that the core module 11 at least partially rests against the concha cavity through the flexible insert block 1131. In other words, a portion of the core shell 111 that extends into the concha cavity and is in contact with the concha cavity may be covered by the flexible insert block 1131. In this way, when the core module 11 rests against the concha cavity, for example, when the core module 11 and the hook structure 12 are set to jointly clamp the ear from the front side and the rear side of an ear region corresponding to the concha cavity of the ear, the flexible insert block 1131 serves as a cushioning effect between the core shell 111 and the ear (e.g., the ear region) to alleviate the pressure of the earphone 10 on the ear, which is conducive to improving the comfort of the earphone 10 in the wearing state.

For example, the flexible insert block 1131 successively covers at least a portion of the core shell 111 corresponding to the rear side surface RS, the upper side surface US, and the lower side surface LS. For example, a region of the core shell 111 corresponding to the rear side surface RS is covered by more than 90% of the flexible insert block 1131, and a region of the core shell 111 corresponding to the upper side surface US and the lower side surface LS is covered by about 30% of the flexible insert block 1131. This is so as to take into account the comfort of the earphone 10 in the wearing state and the need to provide structural parts such as the speaker 112 in the core shell 111.

In some embodiments, the flexible insert block 1131 may be set in a U-shape when viewed along the thickness direction X.

In some embodiments, a portion of the flexible insert block 1131 corresponding to the lower side surface LS rests against the antihelix. A thickness of the portion of the flexible insert block 1131 corresponding to the rear side surface RS may be less than a thickness of a portion of the flexible insert block 1131 corresponding to the upper side surface US and a thickness of a portion of the flexible insert block 1131 corresponding to the lower side surface LS, respectively, so as to provide good comfort even when the core module 11 rests against an uneven position within the concha cavity.

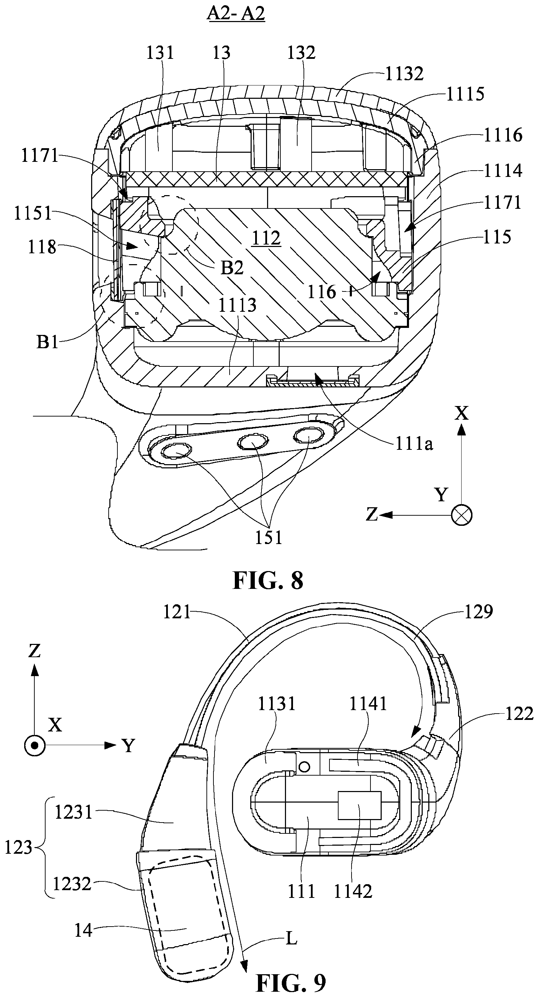

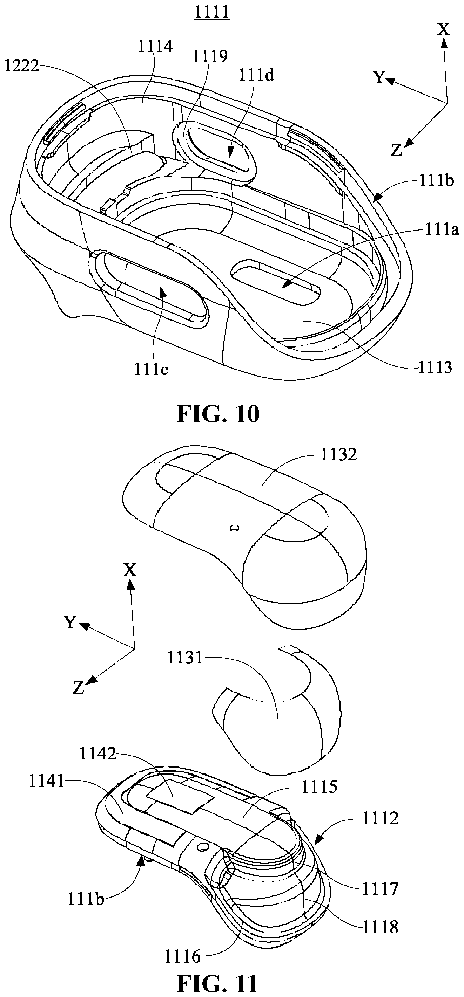

For example, in conjunction with FIG. 7 and FIG. 8, the core shell 111 includes a core inner shell 1111 and a core outer shell 1112 that are snapped together with each other along the thickness direction X. The core inner shell 1111 is closer to the ear in the wearing state compared to the core outer shell 1112. A parting surface 111b between the core outer shell 1112 and the core inner shell 1111 is inclined toward a side where the core inner shell 1111 is located in a direction proximate to the free end FE, which enables the flexible insert block 1131 to be set in a region of the core outer shell 111 corresponding to the free end FE as much as possible. For example, in conjunction with FIG. 11, the flexible insert block 1131 is wholly set in the region of the core outer shell 111 corresponding to the free end FE to simplify a structure of the core module 11 and to reduce a processing cost.

For example, in combination with FIG. 7, FIG. 8, and FIG. 11, the core module 11 includes a flexible cladding layer 1132, and a hardness of the flexible cladding layer 1132 is less than the hardness of the core shell 111. The core shell 111 may be a plastic component, and the flexible cladding layer 1132 may be made of silicone, rubber, etc., and may be formed on a preset region of the core shell 111 by injection molding, glue attachment, etc. Further, the flexible cladding layer 1132 may integrally cover at least a portion of an outer surface of the flexible insert block 1131 and at least a portion of an outer surface of the core outer shell 1112 that is not covered by the flexible insert block 1131, thus favorably enhance the consistency of the core module 11 in appearance. The flexible cladding layer 1132 may be further covered on an outer surface of the core inner shell 1111. The hardness of the flexible insert block 1131 is less than the hardness of the flexible cladding layer 1132, which allows the flexible insert block 1131 to be soft enough. In addition, the flexible cladding layer 1132 also improves the comfort of the earphone 10 in the wearing state and has a certain structural strength to protect the flexible insert block 1131. Further, an area of the outer surface of the flexible insert block 1131 may be within a range of 126 mm² to 189 mm². If the area is too small, it may lead to a deterioration in the comfort of the core module 11 when worn. If the area is too large, it could result in the core module 11 becoming oversized, and deviating from the original intent of the flexible insert block 1131, as the excessive area would prevent it from making contact with the concha cavity. Further, a thickness of the flexible cladding layer 1132 is less than a thickness of the core outer shell 1112.

For example, in conjunction with FIG. 11 and FIG. 9, the core module 11 includes a metallic function pattern such as an antenna pattern 1141 and/or a touch pattern 1142 arranged between the core outer shell 1112 and the flexible cladding layer 1132. The antenna pattern 1141 may be molded on an outer side of the core outer shell 1112 through laser-direct-structuring (LDS) technology. The touch pattern 1142 may be molded on the outer side of the core outer shell 1112 through laser-direct-structuring (LDS) technology, or it may be a flexible touch circuit board pasted on the outer side of the core outer shell 1112. Further, the core outer shell 1112 is provided with metalized holes connected to the antenna pattern 1141 and the touch pattern 1142, respectively. At this time, since the main control circuit board 13 is arranged in the core shell 111, for example, the main control circuit board 13 is connected to the core outer shell 1112, such that the main control circuit board 13 can be in contact with an inner wall of a corresponding metalized hole by means of, e.g., a pogo-PIN, metal shrapnel, and other elastic metal parts, such as the antenna pattern 1141 and the touch pattern 1142 are connected to a pogo-PIN 131 and a pogo-PIN 132, respectively, soldered to the main control circuit board 13. Correspondingly, the speaker 112 is arranged on a side of the main control circuit board 13 that is backed away from the core outer shell 1112. In this way, compared to the antenna pattern 1141 and the touch pattern 1142 being provided on the inner side of the core outer shell 1112 toward the speaker 112, respectively, the antenna pattern 1141 provided on the outer side of the core outer shell 1112 can increase a distance between the antenna pattern 1141 and the main control circuit board 13, that is, increase an antenna headroom region, and thus increase the anti-jamming capability of the antenna pattern 1141. The touch pattern 1142 provided on the outer side of the core outer shell 1112 can shorten a distance between the touch pattern 1152 and an external signal trigger source (e.g., a user's finger), i.e., reducing a touch distance, thereby increasing the sensitivity of the touch pattern 1142 to be triggered by the user.

In some embodiments, the antenna pattern 1141 surrounds a periphery of the touch pattern 1142 to fully utilize a space outside the core outer shell 1112. The antenna pattern 1141 may be provided in a U-shape and the touch pattern 1142 may be provided in a square shape.

Further, the core module 11 includes a microphone 133 soldered to the main control circuit board 13, and the microphone 133 picks up the user's voice and ambient sounds through a pickup through-hole arranged on the core outer shell 1112. The microphone 133 may be further held down on the core outer shell 1112 when the main control circuit board 13 is connected to the core outer shell 1112.

For example, in conjunction with FIG. 10 and FIG. 11, the core inner shell 1111 includes a bottom wall 1113 and a first side wall 1114 connected to the bottom wall 1113, and the core outer shell 1112 includes a top wall 1115 and a second sidewall 1116 connected to the top wall 1115, and the second sidewall 1116 and the first sidewall 1114 are snapped to each other along the mold parting line 111b, and both are supported by each other. When viewed along the width direction Z and in a reference direction (e.g., a direction opposite to an arrow Y in FIG. 10 and FIG. 11) in which the connection end CE points to the free end FE, a portion of the first side wall 1114 proximate to the free end FE is progressively closer to the bottom wall 1113 in the thickness direction X, and a portion of the second side wall 1116 proximate to the free end FE is progressively farther away from the top wall 1115 in the thickness direction X, such that the mold parting line 111b is inclined in a direction proximate the free end FE toward a side on which the core inner shell 1111 is located. At this point, the flexible insert block 1131 is at least partially disposed on an outer side of the second side wall 1116. For example, in combination with FIG. 11 and FIG. 9, the flexible insert block 1131 is partially disposed on an outer side of the top wall 1115 in addition to the outer side of the second side wall 1116. Correspondingly, the sound outlet hole 111a is disposed on the bottom wall 1113. It should be understandable that the sound outlet hole 111a may also be provided on a side of the first side wall 1114 corresponding to the lower side surface LS, and may also be provided at a corner between the first side wall 1114 and the bottom wall 1113. Furthermore, the antenna pattern 1141 and the touch pattern 1142 and their respective metalized holes may be provided on the top wall 1115, and the pickup through-hole of the microphone 133 may also be provided on the top wall 1115.

For example, in conjunction with FIG. 7 and FIG. 11, the core outer shell 1112 is provided with an embedding groove at least partially disposed on the second side wall 1116, the flexible insert block 1131 is embedded in the embedding groove such that an outer surface of a region of the core outer shell 1112 that is not covered by the flexible insert block 1131 is in continuous transition with an outer surface of the flexible insert block 1131. A region where the flexible insert block 1131 is located shown in FIG. 7 can be simply regarded as the embedding groove. In this way, it is not only conducive for the flexible insert block 1131 to be piled up on the core outer shell 1112 during an injection molding process, avoiding overflow of the flexible insert block 1131, but also enhances the aesthetic quality of the core module 11, ensuring a smooth surface without pits.

Further, the second side wall 1116 includes a first sub-side wall segment 1117 and a second sub-side wall segment 1118 connected to the first sub-side wall segment 1117. The first sub-side wall segment 1117 is closer to the top wall 1115 in the thickness direction X compared to the second sub-sidewall segment 1118, and the second sub-side wall segment 1118 protrudes toward an outer side of the core shell 111 more compared to the first sub-sidewall segment 1117. In short, the second side wall 1116 may be in a step-like structure. In this way, it is not only conducive for the flexible insert block 1131 to be piled up on the core outer shell 1112 during the injection molding process, presenting overflow of the flexible insert block 1131, but also conducive for the core module 11 to better rest against the concha cavity through the flexible insert block 1131, thereby improving the comfort of the earphone 10 in the wearing state.

Further, the main control circuit board 13 is connected to the core outer shell 1112, e.g., secured to a thermally fused post connected to the top wall 1115, and partially overlaps with the first sub-side wall segment 1117 in the thickness direction X. The speaker 112 partially overlaps the second sub-side wall segment 1118 in the thickness direction X. In this way, it is advantageous to provide a sufficiently large speaker 112 in the core shell 111 to enhance the volume of sound produced by the earphone 10.

For example, in combination with FIG. 10 and FIG. 8, the core shell 111 is provided with a pressure relief hole 111c. The pressure relief hole 111c enables a space on a side where the speaker 112 is toward the main control circuit board 13 to be connected to the external environment, i.e., air can freely move in and out of the space. In this way, it is conducive to reducing a resistance of a vibration diaphragm of the speaker 112 during vibration. The pressure relief hole 111c may be oriented toward the top of the head in the wearing state, which is favorable to preventing sound waves propagated through the pressure relief hole 111c from forming a sound leakage (i.e., the second sound leakage) from being heard. Based on a Helmholtz resonance cavity, an aperture of the pressure relief aperture 111c may be as large as possible to allow a resonance frequency of the second sound leakage to be shifted as much as possible towards bands of higher frequency (e.g., frequency ranges greater than 4 kHz), which further prevents the second sound leakage from being heard.

Further, the core shell 111 is provided with a sound tuning hole 111d. The sound tuning hole 111d causes the resonance frequency of the second sound leakage to be shifted as much as possible towards bands of higher frequency (e.g., frequency ranges greater than 4 kHz), which further prevents the second sound leakage from being heard. An area of the sound tuning hole 111d may be smaller than an area of the pressure relief hole 111c to allow more of the space on the side where the speaker 112 is toward the main control circuit board 13 to be connected to the external environment through the pressure relief hole 111c. Furthermore, a distance between the sound outlet hole 111a and the pressure relief hole 111c in the width direction Z is greater than a distance between the sound outlet hole 111a and the sound tuning hole 111d in the width direction Z, so as to prevent the sound waves propagated through the sound outlet hole 111a and the pressure relief hole 111c from canceling each other in the near-field, which is conducive to increasing the volume of the sound propagating through the sound outlet hole 111a heard by the user. Correspondingly, the sound tuning hole 111d is located closer to the connection end CE than the sound outlet hole 111a to increase a distance between the sound tuning hole 111d and the connection end CE in the length direction Y, so as to prevent sound waves propagated through the sound outlet hole 111a and the sound tuning hole 111d from canceling out in the near-field, which is conducive to increasing the volume of the sound propagating through the sound outlet hole 111a heard by the user.

For example, in conjunction with FIG. 10, the sound outlet hole 111a, the pressure relief hole 111c, and the sound tuning hole 111d are arranged on the core inner shell 1111, for example, the sound outlet hole 111a is arranged on the bottom wall 1113 while the pressure relief hole 111c and the sound tuning hole 111d are arranged on the first side wall 1114. For example, the pressure relief hole 111c and the sound tuning hole 111d are arranged on opposite sides of the first side wall 1114 along the width direction Z, respectively. In this way, since the sound outlet hole 111a, the pressure relief hole 111c, and the sound tuning hole 111d are all arranged on the core inner shell 1111, it makes the structure of the core outer shell 1112 simpler, which is conducive to reducing the processing cost. In addition, since the pressure relief hole 111c and the sound tuning hole 111d are arranged on opposite sides of the first side wall 1114 along the width direction Z, respectively, the mold parting line 111b may be symmetrically arranged about a reference plane perpendicular to the width direction Z, which is conducive to improving the aesthetic quality of the core module 11.

For example, in conjunction with FIG. 7 and FIG. 8, the core module 11 includes a bracket 115 arranged in the core shell 111. The bracket 115 and the speaker 112 surround to form an acoustic cavity 116 to enable the acoustic cavity 116 to be separated from other structures (e.g., the main control circuit board 13) in the core shell 111, which is conducive to improving the acoustic performance of the core module 11. The core shell 111 is provided with an acoustic hole. For example, the acoustic hole is at least one of the pressure relief hole 111c and the sound tuning hole 111d. The bracket 115 is provided with an acoustic channel 1151 that is in communication with the acoustic hole and the acoustic cavity 116, so that the acoustic cavity 116 is in communication with the external environment, i.e., air can freely flow in and out of the acoustic cavity 116, which is conducive to reducing the resistance of the vibration diaphragm of the speaker 112 during vibration.

Further, the bracket 115 cooperates with the core shell 111 to form a first glue-containing groove 1171 encircling at least a portion of the acoustic hole, and the first glue-containing groove 1171 accommodates a first glue for sealing an assembly gap between the bracket 115 and the core shell 111, i.e., realizing waterproof sealing through the first glue, which prevents external elements such as sweat, rain, and other droplets from entering a space inside the core shell 111, where the main control circuit board 13 is located. In this way, based on the Helmholtz resonance cavity, compared to the related technology in which a silicone sleeve is held down on the core shell 111 through the bracket 115 for realizing waterproof sealing, realizing waterproof sealing through the first glue disclosed in the present disclosure can dispense with the silicone sleeve, which is conducive to shortening a length of a portion of the acoustic cavity 116 that connects with the external environment (including the acoustic channel 1151 and the acoustic hole) and enabling the sound leakage (i.e., the second sound leakage) formed by propagating out through the pressure relief hole 111c to be shifted as much as possible to bands of higher frequency (e.g., frequency range of greater than 4 kHz), thereby further avoiding the second sound leakage from being heard.

It should be noted that: when the acoustic hole is the pressure relief hole 111c, the first glue-containing groove 1171 surrounds at least a portion of the pressure relief hole 111c; when the acoustic hole is the sound tuning hole 111d, the first glue-containing groove 1171 surrounds at least a portion of the sound tuning hole 111d; when the acoustic hole are the pressure relief hole 111c and the sound tuning hole 111d, the first glue-containing groove 1171 surrounds at least a portion of the pressure relief hole 111c and the sound tuning hole 111d, respectively. For ease of description and in conjunction with FIG. 8, FIG. 10, and FIG. 12, the present disclosure uses the acoustic hole as the pressure relief hole 111c and the sound tuning hole 111d, with the first glue-containing groove 1171 surrounding at least a portion of the pressure relief hole 111c and the sound tuning hole 111d, respectively, as an example for exemplary description. Further, if a gap between the bracket 115 and the core shell 111 (e.g., the bottom wall 1113) is sufficiently large, or if the bottom wall 1113 and the first side wall 1114 in the core shell 111 are not an integrally molded structural member (i.e., two separate structural members), the first glue-containing groove 1171 may surround all of the acoustic hole, i.e., the first glue-containing groove 1171 is a complete annular structure.

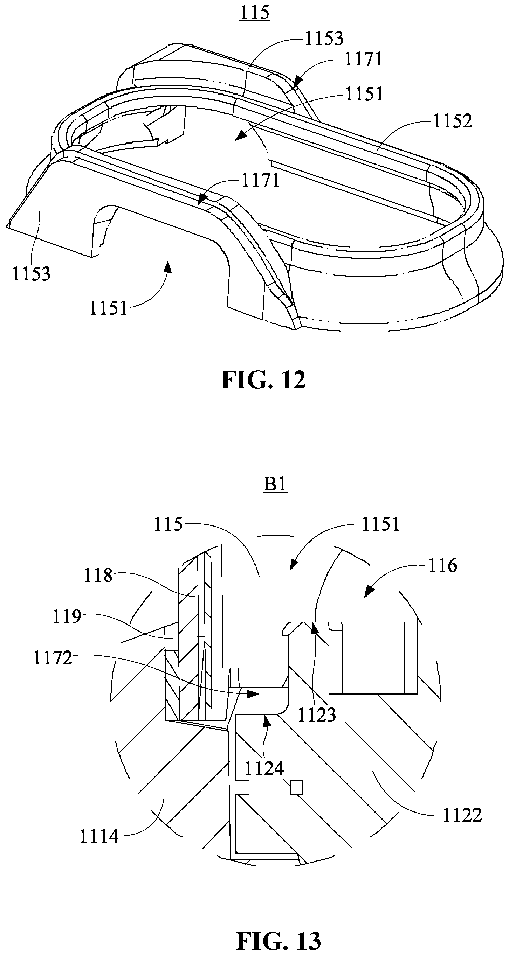

For example, in conjunction with FIG. 12 and FIG. 10, the bracket 115 includes an annular body portion 1152 and a docking portion 1153 connected to the annular body portion 1152. The annular body portion 1152 is socketed to a periphery of the speaker 112 to form the acoustic cavity 116, and the acoustic channel 1151 penetrates through the docking portion 1153 and the annular body portion 1152. Further, the docking portion 1153 is located between the annular body portion 1152 and the core shell 111 and surrounds at least a portion of the acoustic hole, and the docking portion 1153 cooperates with the core shell 111 to form the first glue-containing groove 1171. Since the acoustic hole may be the pressure relief hole 111c and the sound tuning hole 111d, two docking portion 1153 are accordingly arranged, and two first glue-containing grooves 1171 are accordingly arranged. Correspondingly, the docking portion 1153 cooperates with the first side wall 1114 to form the two first glue-containing grooves 1171. In this way, since the bracket 115 is arranged in an annular shape, the speaker 112 is exposed towards a side where the main control circuit board 13 is located, which facilitates to reduce a thickness of the core module 11 in the thickness direction X.

For example, in conjunction with FIG. 10 and FIG. 8, an inner side of the core shell 111 is provided with a recessed region 1119, and the acoustic hole is provided on a bottom of the recessed region 1119. The core module 11 includes an acoustic resistive mesh 118 provided within the recessed region 1119, and the docking portion 1153 presses the acoustic resistive mesh 118 against the bottom of the recessed region 1119. In this way, it is not only beneficial to avoid the bracket 115 from scraping the acoustic resistive mesh 118 during assembly, but also beneficial to narrow an assembly gap between the bracket 115, the acoustic resistive mesh 118, and the core inner shell 1111, as well as prevents the acoustic resistive mesh 118 from wobbling. The acoustic resistive mesh 118 may be pre-fixed to the bottom of the recessed region 1119 by means of double-sided adhesive tape or glue. The acoustic resistive mesh 118 may also be pre-fixed to a protective steel mesh first, and the protective steel mesh is then pre-fixed to the bottom of the recessed region 1119 by means of double-sided adhesive tape or glue. Correspondingly, since the acoustic hole may be the pressure relief hole 111c and the sound tuning hole 111d, two recessed regions 1119 are accordingly arranged, and two acoustic resistive meshes 118 are accordingly arranged.

Further, the first glue may be used to seal an assembly gap between the bracket 115 and the acoustic resistive mesh 118 and/or between the acoustic resistive mesh 118 and the core shell 111 (e.g., a side wall of the recessed region 1119), which further realizes waterproof sealing.

For example, in conjunction with FIG. 8, FIG. 10, and FIG. 12, the docking portion 1153 is configured to form a bottom wall and a side groove wall of the first glue-containing groove 1171, and the core shell 111 is configured to form another side groove wall of the first glue-containing groove 1171. A groove wall on the core shell 111 is arranged opposite a groove wall on the docking portion 1153 so that the first glue-containing groove 1171 has a certain width and depth. The docking portion 1153 is configured to form the side groove wall of the first glue-containing groove 1171, and the core shell 111 is configured to form the bottom wall and another side groove wall of the first glue-containing groove 1171. Alternatively, the docking portion 1153 is configured to form a portion of the side groove wall and the bottom wall of the first glue-containing groove 1171, and the core shell 111 is configured to form a portion of another side groove wall and the bottom wall of the first glue-containing groove 1171.

For example, in conjunction with FIG. 12 to FIG. 14, the speaker 112 includes a body 1121 and an annular bearing platform 1122 arranged in a circumferential direction of the body 1121. A lower end of the bracket 115 is supported on the annular bearing platform 1122. The acoustic channel 1151 is openly arranged on a side toward the annular bearing platform 1122, and the annular bearing platform 1122 further seals an open portion of the acoustic channel 1151. At this point, the first glue-containing groove 1171 can simply be viewed as surrounding a portion of the acoustic hole to allow for the subsequent filling of the first glue-containing groove 1171 with glue during a glue dispensing process.

In some embodiments, the annular bearing platform 1122 includes a first annular bearing surface 1123 and a second annular bearing surface 1124 arranged in a step-like manner, with the second annular bearing surface 1124 surrounding a periphery of the first annular bearing surface 1123. A portion of the lower end of the bracket 115 is supported on the first annular bearing surface 1123, and another portion of the lower end of the bracket 115 forms a spacing region with the second annular bearing surface 1124 to allow the bracket 115, the annular bearing platform 1122, and the core shell 111 to cooperate to form a second glue-containing groove 1172. The second glue-containing groove 1172 accommodates a second glue for sealing an assembly gap between any two of the bracket 115, the annular bearing platform 1122, and the core shell 111 for realizing waterproof sealing correspondingly.

In some embodiments, an upper end of the bracket 115 is lapped over the body 1121 and cooperates with the body 1121 to form a third glue-containing groove 1173. The third glue-containing groove 1173 contains a third glue for sealing an assembly gap between the bracket 115 and the body 1121 for realizing waterproof sealing correspondingly.

It is to be noted that: in a specific assembly process of the core module 11, following steps may be included, and a sequence of all steps before and after may be adjusted as needed: 1) pre-fixing the acoustic resistive mesh 118 to the bottom of the recessed region 1119 by means of a double-sided glue; 2) fixing the speaker 112 to the bottom wall 1113 and dispensing the glue to an assembly gap between the two, with glue piling up on the second annular bearing surface 1124 of the speaker 112; 3) before the glue in 2) is cured, fixing the bracket 115 to the speaker 112, with the lower end of the bracket 115 being supported on the first annular bearing surface 1123 of the speaker 112, so that a region between the lower end of the bracket 115 and the second annular bearing surface 1124 is also filled with the glue, and pressing the docking portion 1153 of the bracket 115 to hold the acoustic resistive mesh 118 and cooperating with the first side wall 1114 to form the first glue-containing groove 1171, with the upper end of the bracket 115 overlaying on the body 1121 and cooperating with the body 1121 to form the third glue-containing groove 1173; and 4) dispensing the glue to the first glue-containing groove 1171, the third glue-containing groove 1173, and the assembly gap between the lower end of the bracket 115, the speaker 112, and the core inner shell 1111. Since the assembly gap between the lower end of the bracket 115, the speaker 112 and the core inner shell 1111 is close to the first glue-containing groove 1171, such that the assembly gap between the lower end of the bracket 115, the speaker 112, and the core inner shell 1111can be simply regarded as a continuation of the first glue-containing groove 1171, i.e., the first glue-containing groove 1171 and the second glue-containing groove 1172 are in communication with each other.

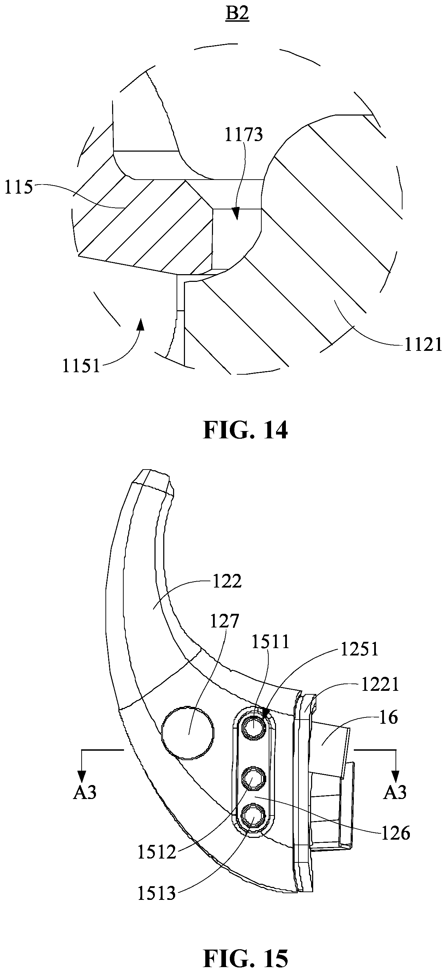

For example, in conjunction with FIG. 15 to FIG. 18 and FIG. 7, the hook structure 12 includes an adapter shell 122 coupled to the core module 11, and the adapter shell 122 forms an accommodation cavity 124 in advance. The earphone 10 includes an electronic element 15 that is subsequently arranged within the accommodation cavity 124. A connection between the adapter shell 122 and the core module 11 may be a snap-fit, a soldered, a glued connection, a threaded connection and a screw connection, and other assembly manners, or a combination thereof. In this way, compared to the related technology in which the electronic element 15 is arranged in the core module 11, the present disclosure not only saves space of the core module 11 by installing the electronic element 15 in the preset accommodation cavity 124 of the hook structure 12, making it more compact and small in structure, but also simplifies the structure of the core module 11 by making it more efficient in assembly, and also conducive to reasonably arranging relative positions of various structural components in the earphone 10, so that both the core module 11 and the hook structure 12 can be fully utilized.

It should be noted that: the adapter shell 122 forming the accommodation cavity 124 refers to that the accommodation cavity 124 is formed at the same time as the adapter shell 122 is molded, rather than being processed and formed after the adapter shell 122 is molded. For example, if the adapter shell 122 is a plastic shell, the accommodation cavity 124 can be obtained by setting an appropriate core during an injection molding process of the plastic shell. Correspondingly, the subsequent arrangement of the electronic element 15 to the accommodation cavity 124 refers to the electronic element 15 and the adapter shell 122 is not an integrally molded structural component. For example, the adapter shell 122 is plastic shell, and the electronic element 15 is integrally injection-molded into the plastic shell without through insert. Based on this, descriptions of the adapter shell 122 forming with a through hole 1251, a blind hole 1252, and a through hole 1253, etc., referred to later in the text, are the same as or similar to those described herein and will not be repeated. It should be understood that the accommodation cavity 124 may also be obtained by means of a drilling process after the adapter shell 122 has been molded, and the through hole 1251, the blind hole 1252, and the through hole 1253, etc., can likewise be obtained by drilling after the adapter shell 122 has been molded.

For example, in conjunction with FIG. 7, the electronic element 15 is coupled with the main control circuit board 13 to realize an electrical connection between the hook structure 12 and the core module 11, and the adapter shell 122 is inserted and fixed with the core shell 111 to realize a structural connection between the hook structure 12 and the core module 11, which is simple and reliable. Being inserted and fixed refers to a process where one of the adapter shell 122 or the core shell 111 is partially inserted into the other along an assembly direction, and then fixed in place through a position-limiting structure, such as a latch, and an assembly direction of the position-limiting structure is different from the assembly direction. Being inserted and fixed refers to that one of the adapter shell 122 and the core shell 111 may be inserted and fixed when it is partially extended into the other without the aid of the position-limiting structures.

For example, in combination with FIG. 7, FIG. 10, and FIG. 16, the adapter shell 122 is provided with a first snap structure 1221, and the core shell 111 is provided with a second snap structure 1222. The first snap structure 1221 extends into the core shell 111 and snaps with the second snap structure 1222, so that the adapter shell 122 and the core shell 111 are directly connected and fixed without the aid of other position-limiting structures, which is simple and reliable. Two first snap structures 1221 may be integrally arranged on the adapter shell 122 and may be spaced apart in the thickness direction X, and two second snap structures 1222 may be integrally arranged on the core inner shell 1111 and arranged in one-to-one correspondence with the first snap structures 1221.

For example, in conjunction with FIG. 7, the earphone 10 includes a flexible circuit board 16. The flexible circuit board 16 is at least partially arranged in the accommodation cavity 124 to be connected to the electronic element 15 and extend into the core shell 111, which in turn allows the electronic element 15 to be connected to the main control circuit board 13 through the flexible circuit board 16. For example, the electronic element 15 is soldered to one end of the flexible circuit board 16 with the aid of Surface Mounted Technology (SMT), and the other end of the flexible circuit board 16 is snapped together with the main control circuit board 13 with the aid of a BTB connector. The speaker 112 is arranged to be connected to the flexible circuit board 16 over an extension path of the flexible circuit board 16, such as a lead of the speaker 112 is soldered to a corresponding region of the flexible circuit board 16, so that the speaker 112 is also connected to the main control circuit board 13 through the flexible circuit board 16, so that the lead of the speaker 112 do not need to be extended to be connected to the main control circuit board 13, which is conducive to simplifying the alignment structure of the earphone 10 and reducing the production cost.

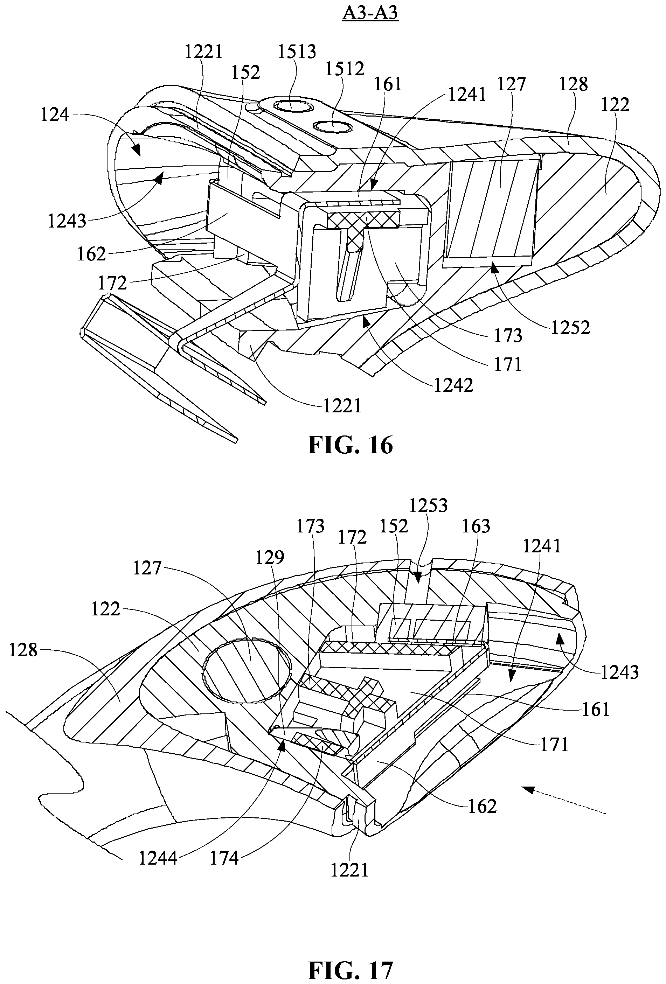

For example, in conjunction with FIG. 16 and FIG. 15, the adapter shell 122 forms the through-hole 1251 in communication with the accommodation cavity 124 in advance, and the electronic element 15 includes an electrode terminal 151 that is at least partially disposed within the through-hole 1251. The electrode terminal 151 may be either a retractable elastic component such as a pogo-PIN or a non-retractable and rigid component such as a metal post. An aperture of the through-hole 1251 may be larger than an outer diameter of the electrode terminal 151 to facilitate the subsequent addition of the electrode terminal 151. It should be understandable that the electrode terminal 151 may also be integrally molded with the adapter shell 122 through insert. Furthermore, the electrode terminal 151 may be oriented toward the ear in the wearing state so that is not visible in the wearing state, which is conducive to improving the aesthetic quality of the earphone 10 in the wearing state.

It should be noted that: when the electrode terminal 151 is set into a retractable elastic component such as a pogo-PIN, an extension direction of the electrode terminal 151 may be a direction in which it is retracted. When the electrode terminal 151 is set into a non-retractable and rigid component such as a metal post, an extension direction of the electrode terminal 151 may be a direction in which its axis lies.

Further, a plurality of electrode terminal 151 may be arranged according to the actual requirements, such as for charging, detecting, or the like.

In some embodiments, the electrode terminal 151 includes a charging positive terminal 1511 and a charging negative terminal 1512 spaced apart from each other, and the charging positive terminal 1511 and the charging negative terminal 1512 may be arranged within a respective through hole 1251 to facilitate charging of the earphone 10 through the electrode terminal 151. It should be understandable that only one of the charging positive terminal 1511 and the charging negative terminal 1512 may be provided on the adapter shell 122, and another may be provided on another shell of the hook structure 12 such as a battery shell 123 or on the core inner shell 1111.

In some embodiments, the electrode terminal 151 includes a detection terminal 1513 spaced apart from the charging positive terminal 1511 and the charging negative terminal 1512, and the detection terminal 1513 is configured to perform detection functions such as a charging detection, an into-or-out of a charging shell detection, or the like. The detection terminal 1513 may also be replaced by an electronic element such as a Hall sensor.

In some embodiments, when viewed along an extension direction of the electrode terminal 151, a line connecting the charging positive terminal 1511, the charging negative terminal 1512, and the detection terminal 1513 two-by-two forms a triangle, such as a positive triangle.

In some embodiments, the charging positive terminal 1511, the charging negative terminal 1512, and the detection terminal 1513 may be spaced apart from each other and arranged as a line segment, such as arranged in a straight line segment, when viewed along the extension direction of the electrode terminal 151. A distance between the charging positive terminal 1511 and the charging negative terminal 1512 may be greater than a distance between the charging negative terminal 1512 and the detection terminal 1513. For example, the charging negative terminal 1512 is located between the charging positive terminal 1511 and the detection terminal 1513, and a distance between the charging positive terminal 1511 and the charging negative terminal 1512 is greater than a distance between the charging negative terminal 1512 and the detection terminal 1513. As another example, the detection terminal 1513 is located between the charging positive terminal 1511 and the charging negative terminal 1512. In this manner, the distance between the charging positive terminal 1511 and the charging negative terminal 1512 is increased as much as possible to avoid short circuits between the two when a space for arranging the electrode terminal 151 on the adapter shell 122 is limited.

For example, in conjunction with FIG. 15, an outer side of the adapter shell 122 is provided with a tab 126, and the through-hole 1251 is further penetrated through the tab 126 to allow a plurality of electrode terminals 151 to be exposed at the tab 126, respectively. In this way, the tab 126 causes the adapter shell 122, which has a certain curvature, to become flat in the locally uneven region, making it easier to set the electrode terminal 151. The charging positive terminal 1511, the charging negative terminal 1512, and the detection terminal 1513 may be spaced apart sequentially along a length direction of the tab 126.

For example, in conjunction with FIG. 15 to FIG. 17, the hook structure 12 includes a magnet 127, and the magnet 127 and the electrode terminal 151 are exposed on a same side of the adapter shell 122, i.e., both are visible on a same side surface of the adapter shell 122 to make the magnet 127 closer to the external environment toward which an exposed end of the electrode terminal 151 faces, thereby shortening a distance between the magnet 127 and a magnetic suction structure used to cooperate with the magnet 127 in a charging device, such as a charging case, or the Hall sensor used to cooperate with the magnet 127, which improves the reliability of functions of charging, detection, or the like. The magnet 127 and the electrode terminal 151 may be provided adjacent to each other to allow the magnet 127 to cooperate with the magnetic suction structure in the charging device, such as a charging case, such that the electrode terminal 151 cooperates with electrode terminals in the charging device to facilitate charging. Correspondingly, the tab 126 protrudes out of the adapter shell 122 around the magnet 127, i.e., the magnet 127 is lower than the tab 126 to allow the electrode terminal 151 to come into contact with the electrode terminals in the charging device, such as the charging case. It should be understood that in an embodiment in which the magnet 127 is used for detection in conjunction with a Hall sensor in a charging device such as a charging case, the magnet 127 is provided adjacent to the electrode terminal 151. It is also possible to make the electrode terminals, which cooperate with the electrode terminal 151, in a charging device such as a charging case, to be provided adjacent to the Hall sensor, which reduces an area required for accommodating both the electrode terminals and the Hall sensor in the charging device like the charging case.

Further, the hook structure 12 includes a flexible cladding layer 128, and a hardness of the flexible cladding layer 128 is less than a hardness of the adapter shell 122. The adapter shell 122 may be a plastic shell, and the flexible cladding layer 128 may be made of silicone, rubber, or the like, and may be formed on the adapter shell 122 by injection molding, gluing connection, or the like. Furthermore, the flexible cladding layer 128 covers the adapter shell 122 and the magnet 127, so that the magnet 127 is not exposed and the electrode terminal 151 is exposed, i.e., the magnet 127 is not visible and the electrode terminal 151 is visible. In this way, the electrode terminal 151 may be used to meet the needs of the electrode terminal 151, and the magnet 127 can be shielded from being worn out or affecting the aesthetic quality due to its exposure. In addition to this, the flexible cladding layer 128 is also conducive to improving the comfort of the earphone 10 in the wearing state. A thickness of the flexible cladding layer 128 is less than a thickness of the adapter shell 122.

For example, in conjunction with FIG. 16, the adapter shell 122 forms the blind hole 1252 in advance which is not in communication with the accommodation cavity 124 to increase the water and dust resistance of the accommodation cavity 124. The magnet 127 may be provided at least within the blind hole 1252 and exposed via an open end of the blind hole 1252. In this way, it is not only beneficial to reduce the thickness of the adapter shell 122 in a region where the magnet 127 is located, but also improves the aesthetic quality of the earphone 10 in the region where the magnet 127 is located. It should be understood that the blind hole 1252 may also be provided as through hole.

For example, in conjunction with FIG. 15, the plurality of electrode terminals 151 may be spaced apart from each other and arranged in a line segment, such as a straight line segment or a zigzag segment, when viewed in an extension direction of the electrode terminals 151. The magnet 127 may be arranged on either side of the line segment, or the magnet 127 intersects the line segment and is at least partially located between any two adjacent electrode terminals 151. For example, a count of the magnet 127 is one, and the magnet 127 is arranged integrally on one side of the line segment, or is intersected by the line segment and located integrally between any two adjacent electrode terminals 151. As another example, the count of the magnet 127 is two, with one magnet 127 being arranged integrally on one side of the line segment and the other magnet 127 being arranged integrally on the other side of the line segment. As another example, the count of the magnet 127 is one, with a portion of the magnet 127 intersecting the line segment and located between any two adjacent electrode terminals 151, and another portion being arranged below the electrode terminals 151 in the extension direction.

For example, in conjunction with FIG. 15, the plurality of electrode terminals 151 includes the charging positive terminal 1511, the charging negative terminal 1512, and the detection terminal 1513 that are arranged in a straight line segment. The magnet 127 may be located on one side of the straight line segment. Furthermore, when viewed along the extension direction of the electrode terminal 151, there is a first distance, a second distance, and a third distance between a center of the magnet 127 and a center of the charging positive terminal 1511, the center of the magnet 127 and a center of the charging negative terminal 1512, and the center of the magnet 127 and a center of the detection terminal 1513, respectively, the third distance being greater than the first distance and the second distance, respectively, to prioritize charging reliability. It is worth noting that: in an embodiment in which the hook structure 12 is provided with the flexible cladding layer 128, in order to conveniently determine a relative positional relationship between the magnet 127, the charging positive terminal 1511, the charging negative terminal 1512, and the detection terminal 1513, the flexible cladding layer 128 may be removed first.

For example, in conjunction with FIG. 16 to FIG. 18, the electronic element 15 includes the electrode terminal 151 and a microphone 152. The adapter shell 122 forms the accommodation cavity 124, the through hole 1251, and the through hole 1253 that are in communication with the accommodation cavity 124, respectively, in advance. Due to different roles of the electrode terminal 151 and the microphone 152, the through hole 1251 and the through hole 1253 may be arranged on different side walls of the adapter shell 122. Based on this, the electrode terminal 151 may be at least partially disposed within the through hole 1251, and the microphone 152 may be disposed within the accommodation cavity 124 and pick up sounds (e.g., a user voice, an environmental sound) outside the earphone 10 via the through hole 1253. In this way, by reasonably arranging relative positions of the electrode terminal 151 and the microphone 152, a space of the accommodation cavity 124 is fully utilized, and a structure of the earphone 10 is thus more compact and smaller. Further, the earphone 10 includes a support assembly 17 at least partially arranged in the accommodation cavity 124, and the support assembly 17 supports and fixes the electrode terminal 151 and the microphone 152 on side walls corresponding to the through hole 1251 and the through hole 1253, respectively. In this way, it is not only conducive to preventing the electrode terminal 151 and the microphone 152 from separating from the adapter shell 122, but also conducive to increasing the waterproof and dustproof performance at the electronic element 15 with a simple and reliable structure.

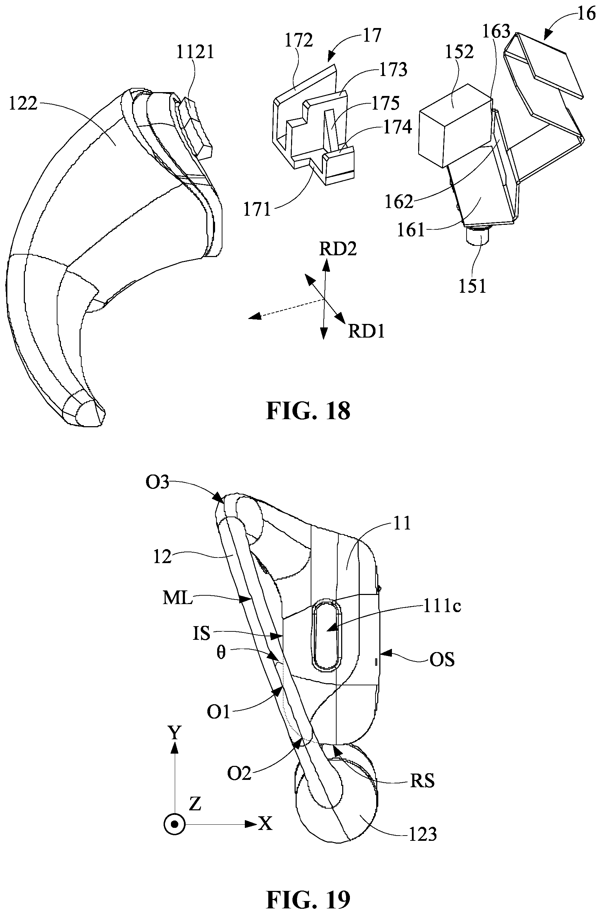

For example, in conjunction with FIG. 18, the flexible circuit board 16 includes a first circuit board portion 161, a second circuit board portion 162, and a third circuit board portion 163 of a one-piece structure. The electrode terminal 151 is soldered to the first circuit board portion 161, the second circuit board portion 162 is bent with respect to the first circuit board portion 161, and the microphone 152 is soldered to the third circuit board portion 163 and bent with respect to the second circuit board portion 162. In other words, after the flexible circuit board 16 has been bent twice, the first circuit board portion 161, the second circuit board portion 162, and the third circuit board portion 163 correspond to three adjacent surfaces of a hexagonal structure. An end of the second circuit board portion 162 away from the third circuit board portion 163 is connected to the first circuit board portion 161, and the other portion of the second circuit board portion 162 is not connected to the first circuit board portion 161. This is to allow an operator to press the end of the second circuit board portion 162 that is connected to the first circuit board portion 161 first, after the flexible circuit board 16 and the electrode terminal 151 and microphone 152 thereon are assembled in the adapter shell 122, so that the end is flush with the first circuit board portion 161 as much as possible, making room for the subsequently assembled support assembly 17.

In some embodiments, the adapter shell 122 includes two shells whose mold parting lines are perpendicular to the extension direction of the electrode terminal 151, the two shells being snapped together with each other to form the accommodation cavity 124. The support assembly 17 may be integrally molded with one of the shells to support (or hold down) the electrode terminal 151 and the microphone 152, respectively, when the two shells are snapped together. Alternatively, at least one of a first support member for supporting the electrode terminal 151 and a second support member for supporting the microphone 152 in the support assembly 17 may be independent of the adapter shell 122 to support (or press) the electrode terminal 151 and the microphone 152, respectively, when the two shells are snapped together. Or, after the two shells are snapped together, the support assembly 17 is then assembled to support (or press) the electrode terminal 151 and microphone 152, respectively.

In some embodiments, at least a portion of the adapter shell 122 that corresponds to the accommodation cavity 124 is a complete shell structure. At least the first support member among the first support member of the support assembly 17 for supporting the electrode terminal 151 and the second support member of the support assembly 17 for supporting the microphone 152 may be independent of the adapter shell 122 to at least facilitate the assembly of the electrode terminal 151.

For example, in conjunction with FIG. 18, the support assembly 17 is independent of the adapter shell 122 and inserted into the accommodation cavity 124. In this way, since the support assembly 17, the electrode terminal 151, and the microphone 152 can be independent of the adapter shell 122 respectively, they can be assembled according to a certain sequence, which is conducive to avoiding unnecessary interferences in structure, making the assembly efficient.

In some embodiments, the first support member for supporting the electrode terminal 151 and the second support member for supporting the microphone 152 in the support assembly 17 may be independent of the adapter shell 122, i.e., the first support member and the second support member are independent of each other to support (or press) the electrode terminal 151 and the microphone 152, respectively. This is done so as to allow the first support member and the second support member in the support assembly 17 to be differentiated according to actual needs.

In some embodiments, the support assembly 17 may be a one-piece molded structural member, that is, the first support member for supporting the electrode terminal 151 and the second support member for supporting the microphone 152 in the support assembly 17 are connected to each other, which is not only conducive to simplifying a structure of the support assembly 17, but also avoids the first support member and the second support member being too small and difficult to assemble. The support assembly 17 can be fixed in a tight fit with a cavity wall of the accommodation cavity 124 after it is inserted into place, i.e., the support assembly 17 is inserted or withdrawn with a certain amount of damping, and the structure is simple and reliable. Correspondingly, the cavity wall of the accommodation cavity 124 may be provided with a guide groove and a position-limiting groove with which the support assembly 17 fits. It should be understood that the support assembly 17 may be further glued to the cavity wall of the accommodation cavity 124 through a dispensing process.

For example, in conjunction with FIG. 17 and FIG. 18, a dimension of at least a portion of the support assembly 17 and the accommodation cavity 124 in at least one reference direction perpendicular to an insertion direction (e.g., a direction indicated by arrows in FIG. 17 and FIG. 18) of the support assembly 17 with respect to the accommodation cavity 124 may be set to become progressively smaller along the insertion direction, which facilitates the extension of the support assembly 17 into an interspaced region between the electrode terminal 151 and the microphone 152. In other words, at least a portion of the dimension of the support assembly 17 in at least one reference direction perpendicular to the insertion direction may be set to become progressively smaller along the insertion direction, and the dimension of at least a portion of the accommodation cavity 124 in the reference direction may be set to become progressively smaller along the insertion direction, and both of them have a same or similar change trend, which facilitates the support assembly 17 to be tightly fitted and fixed with the cavity wall of the accommodation cavity 124 after being inserted in place.

For example, in conjunction with FIG.16 to FIG.18, the cavity wall of the accommodation cavity 124 includes a first cavity wall 1241 and a second cavity wall 1242 arranged side-by-side and spaced apart from each other, and a third cavity wall 1243 connecting the first cavity wall 1241 and the second cavity wall 1242. The through hole 1251 may be arranged on the first cavity wall 1241 and the through hole 1253 may be arranged on the third cavity wall 1243. Correspondingly, the support assembly 17 includes a bottom plate 171 and a first side plate 172 connected to the bottom plate 171, e.g., in an L-shaped structure. A main surface on one side of the bottom plate 171 may be arranged opposite the first cavity wall 1241 and support the electrode terminal 151, and a main surface on one side of the first side plate 172 may be arranged opposite the third cavity wall 1243. In this manner, after the electrode terminal 151 and the microphone 152 are assembled in place, after the support assembly 17 is inserted into the accommodation cavity 124 in the insertion direction and is in place, it can support the electrode terminal 151 and the microphone 152, respectively through the bottom plate 171 and the first side plate 172.

Furthermore, an orthographic projection of the microphone 152 on the first cavity wall 1241 covers at least a portion of the electrode terminal 151, such as the microphone 152 covers a portion of the charging positive terminal 1511, which facilitates a more compact structure of each part of the earphone 10.

In some embodiments, a dimension of at least a portion of the bottom plate 171 and the accommodation cavity 124 in a first reference direction RD1, which is perpendicular to the insertion direction and parallel to the main surface on one side of the bottom plate 171, may be set to become progressively smaller along the insertion direction, i.e., a dimension of one of a front end and a rear end or a dimension of a localized region between the front end and the rear end of the bottom plate 171 in the insertion direction may be set remain unchanged in the first reference direction RD1 along the insertion direction. A dimension of the first side plate 172 and the accommodation cavity 124 in the second reference direction RD2, which is perpendicular to the insertion direction and parallel to the main surface on one side of the first side plate 172, may be set to remain unchanged in the first reference direction RD1 along the insertion direction.

In some embodiments, a dimension of at least a portion of the first side plate 172 and the accommodation cavity 124 in a second reference direction RD2, which is perpendicular to the insertion direction and parallel to the main surface on one side of the first side plate 172 may be set to become progressively smaller in the second reference direction RD2 along the insertion direction, i.e., a dimension of one of a front end and a rear end, or a dimension of a localized region between the front end and the rear end of the first side plate 172 in the second reference direction RD2 may be set to remain unchanged along the insertion direction. A dimension of the bottom plate 171 and the accommodation cavity 124 in the first reference direction RD1, which is perpendicular to the insertion direction and parallel to the main surface on one side of the bottom plate 171, may be set to remain unchanged in the second reference direction RD2 along the insertion direction.

In some embodiments, a dimension of at least a portion of the first side plate 172 and the accommodation cavity 124 in the second reference direction RD2, which is perpendicular to the insertion direction and parallel to the main surface on one side of the first side plate 172 may be set to gradually become smaller along the insertion direction.

It should be noted that for the support assembly 17, the dimension of the bottom plate 171 in the first reference direction RD1 can be simply regarded as a width of the bottom plate 171, and the dimension of the first side plate 172 in the second reference direction RD2 can be simply regarded as a height of the first side plate 172.

For example, in conjunction with FIG. 16 to FIG. 18, the support assembly 17 includes a second side plate 173 connected to the bottom plate 171. The second side plate 173 and the first side plate 172 are arranged side-by-side with each other and spaced apart on a same side of the bottom plate 171. The second side plate 173 resists a second cavity wall 1242 to provide a support force for the bottom plate 171 toward the electrode terminal 151, which is conducive to improving the support effect of the support assembly 17 on the electrode terminal 151. In an embodiment in which the electrode terminal 151 includes the charging positive terminal 1511 and the charging negative terminal 1512 spaced apart from each other along a direction perpendicular to the insertion direction, the second side plate 173 may be arranged between the charging positive terminal 1511 and the charging negative terminal 1512, so as to make a force on various portions of the electrode terminal 151 uniform, which is conducive to further improving the support effect of the support assembly 17 on the electrode terminal 151.

For example, in conjunction with FIG. 16 to FIG. 18, the cavity wall of the accommodation cavity 124 includes a fourth cavity wall 1244 that connects the first cavity wall 1241 and the second cavity wall 1242 and opposes the third cavity wall 1243. The first cavity wall 1241 and the second cavity wall 1242 may be substantially set into a planar structure parallel to each other, and the third cavity wall 1243 and the fourth cavity wall 1244 may be substantially set into a curved structure flared out from each other to maximize a volume of the accommodation cavity 124 when a volume of the adapter shell 122 is limited.
Correspondingly, the support assembly 17 includes a third side plate 174 connected to the bottom plate 171. The first side plate 172 and the third side plate 174 are arranged on two side edges of the bottom plate 171, respectively, in a direction perpendicular to the insertion direction. The second side plate 173 is arranged between the first side plate 172 and the third side plate 174. The third side plate 174 rests against the fourth cavity wall 1244 to provide a support force for the first side plate 172 toward the microphone 152, which is conducive to improving the support effect of the support assembly 17 on the microphone 152.

Further, a height of the second side plate 173 may be greater than a height of the first side plate 172 and a height of the third side plate 174, respectively, with respect to the bottom plate 171 to allow for the second side plate 173 to reset against the second cavity wall 1242 and the third side plate 174 against the fourth cavity wall 1244. The second side plate 173 and the third side plate 174, due to not being in direct contact with either of the electrode terminal 151 and the microphone 152, can play a guiding role when the support assembly 17 is inserted into the accommodation cavity 124. Correspondingly, the relatively highest height of the second side plate 173 allows the support assembly 17 to include a reinforcement 175 connecting the second side plate 173 and the bottom plate 171. The reinforcement 175 may be provided on opposite sides of the second side plate 173 toward the first side plate 172 and the third side plate 174.

For example, in conjunction with FIG. 15 to FIG. 17 and FIG. 9, the hook structure 12 includes the elastic metal wire 121, the adapter shell 122, the battery shell 123, and a conductor 129. The elastic metal wire 121 and two ends of the conductor 129 are connected to the adapter shell 122 and the battery shell 123, respectively, to allow the conductor 129 to extend along the elastic metal wire 121 and be threaded within the adapter shell 122 and the battery shell 123. It should be understood that the conductor 129 may also be threaded within a preset threading channel after the elastic metal wire 121 is connected to the adapter shell 122 and the battery shell 123. The battery 14 may be arranged in the battery shell 123 and may be connected to the flexible circuit board 16 through the conductor 129, which in turn allows the battery 14 to be connected to the main control circuit board 13 through the flexible circuit board 16 as well, thereby simplifying an alignment structure of the earphone 10 and reducing production costs. In other words, components such as the electrode terminal 151, the microphone 152, and the battery 14 in the hook structure 12 can be connected to the main control circuit board 13 through the flexible circuit board 16.

Furthermore, the flexible cladding layer 128 may at least further encapsulate an exposed portion of the elastic metal wire 121 and the conductor 129, as well as at least a portion of the battery 123, so as to facilitate the conductor 129 to be exposed, which improves the aesthetic quality of the earphone 10.

It should be noted that the adapter shell 122 may also be structured as part of the core shell 111, such as where the adapter shell 122 is integrally molded with the core inner shell 1111, or where a portion of the adapter shell 122 is integrally molded with the core inner shell 1111 and a remaining portion of the adapter shell 122 is integrally molded with the core outer shell 1112. A portion of the hook structure 12 other than the adapter shell 122, such as an end of the elastic metal wire 121 that is away from the battery shell 123, or the battery shell 123, is integrally fixed and connected to the core module 11 at the adapter shell 122, such as being fixed through insertion. Correspondingly, structural components such as the electrode terminal 151, the microphone 152, and the magnet 127 are consequently positionally adjusted, as will not be described herein.

Based on the foregoing description, the present disclosure provides a shell assembly, including a plastic shell, a metal function pattern, and a silicone cladding layer. The metal function pattern is disposed on an outer side of the plastic shell, and the silicone cladding layer covers a side of the metal functional pattern facing away from the plastic shell, as well as a region of the plastic shell that is not covered by the metal functional pattern, using methods such as integrally injection molding or adhesive bonding. Thus, compared to the metal functional pattern being arranged on an inner side of the plastic shell away from the silicone cladding layer, the metal functional pattern is arranged on the outer side of the plastic shell facing the silicone cladding layer, which reduces interference from other electronic components inside the shell assembly or brings the metal functional pattern closer to an external signal trigger source, thereby enhancing the metal functional pattern's resistance to interference and sensitivity. A structure of the plastic shell may be the same as or similar to that of the core shell 111 or the core outer shell 1112 thereof, and a structure of the silicone cladding layer may be the same as or similar to that of the flexible cladding layer 1132, and will not be repeated herein.

In some embodiments, the metal function pattern may be set as the antenna pattern 1141 or the touch pattern 1142. The antenna pattern 1141 is provided on an outer side of the plastic shell, which can increase a distance between the antenna pattern 1141 and other electronic components in the plastic shell, i.e., enlarge an antenna headroom region, thereby increasing the anti-jamming capability of the antenna pattern 1141. The touch pattern 1142 is provided on the outer side of the plastic shell, which shortens a distance between the touch pattern 1142 and an external signal triggering source (e.g., the user's finger), i.e., reducing a touching distance and increasing the sensitivity of the touch pattern 1142 to be triggered by the user.

In some embodiments, the metal functional pattern includes the antenna pattern 1141 and the touch pattern 1142, and the antenna pattern 1141 may surround a periphery of the touch pattern 1142 to fully utilize a space on the outer side of the plastic shell. The antenna pattern 1141 may be provided in a U-shape, and the touch pattern 1142 may be provided in a square shape.

In some embodiments, a thickness of the silicone cladding layer may be less than a thickness of the plastic shell to further increase the anti-interference property and sensitivity of the metal functional pattern while the silicone cladding layer masks and protects the metal functional pattern, as well as to reduce a volume of the shell assembly.

For example, the shell assembly serves as a core shell that accommodates the speaker 112. In this regard, a relative positional relationship between the plastic shell and the silicon cladding layer may be the same as or similar to that between the core shell 111 and the flexible cladding layer 1132, and will not be repeated herein.

Further, the shell assembly may be applied to other electronic devices such as smart glasses in addition to the earphone 10. The electronic device may include a core module provided with the speaker 112, and may also include the main control circuit board 13, the speaker 112 and the battery 14 coupled to the main control circuit board 13, respectively. The shell assembly may be configured to accommodate at least one of electronic components, such as the speaker 112, the main control circuit board 13, and the battery 14, and may also be configured to support the speaker 112 in the electronic device at a corresponding wearing position. It is worth noting that: for electronic devices such as earphones, smart glasses, or the like based on a principle of bone conduction, the speaker 112 may be adaptively adapted to be a bone-conduction speaker, and a basic structure of the bone-conduction speaker is well known to those skilled in the art and will not be repeated herein.

The present disclosure provides a shell assembly, including a first shell, the electrode terminal 151, the magnet 127, and the flexible cladding layer 128. The electrode terminal 151 and the magnet 127 are exposed on a same side of the first shell, a hardness of the flexible cladding layer 128 is less than a hardness of the first shell, and the flexible cladding layer 128 covers the first shell and the magnet 127 such that the magnet 127 is not exposed while the electrode terminal 151 is exposed. In this way, compared to the magnet 127 being arranged in the first shell, the present disclosure allows the magnet 127 to be located closer to the external environment toward which an exposed end of the electrode terminal 151 faces, thereby shortening a distance between the magnet 127 and a magnetic suction structure in a charging device such as a charging case used to cooperate with the magnet 127 or a distance between the magnet 127 and a Hall sensor in a charging device used to cooperate with the magnet 127, which is conducive to improving the reliability of functions such as charging, detection, or the like. Thus, the shell assembly can be applied to both a powered device such as the earphone 10, smart glasses, and a charging device such as a charging case. In other words, the electronic device can be both a powered device and a charging device. For ease of description, the first shell may be the adapter shell 122.

In some embodiments, the first shell is provided with the through hole 1251 and the blind hole 1252. The electrode terminal 151 may be at least partially arranged within the through hole 1251, and the magnet 127 may be at least partially arranged within the blind hole 1252 and exposed via an open end of the blind hole 1252. In this way, it is not only beneficial to reduce a thickness of the first shell in a region where the magnet 127 is located, but also beneficial to improve the aesthetic quality of the first shell in the region where the magnet 127 is located. The blind hole 1252 may also be provided as a through hole.

In some embodiments, an outer side of the first shell is provided with the tab 126, the tab 126 is provided adjacent to the magnet 127 and protrudes out of the first shell around the magnet 127. The through hole 1251 is further threaded through the tab 126 to allow a plurality of electrode terminals 151 are each exposed at the tab 126. In this way, the tab 126 flattens a locally uneven region of the first shell, which has a certain curvature, to facilitate the placement of the electrode terminal 151. The tab 126 may be provided in an elongate shape, which is simple and reliable.

In some embodiments, the shell assembly includes the flexible circuit board 16, with the electrode terminal 151 being connected to the flexible circuit board 16 to simplify alignment of the electrode terminal 151. The first shell forms the accommodation cavity 124 in advance. At least a portion of the flexible circuit board 16 is arranged in the accommodation cavity 124, the through hole 1251 is in communication with the accommodation cavity 124, and the blind hole 1252 is not in communication with the accommodation cavity 124, so as to improve the waterproof and dustproof performance of the first shell.

In some embodiments, the shell assembly includes a second shell, the elastic metal wire 121, and the conductor 129. Two ends of the elastic metal wire 121 and two ends of the conductor 129 may be connected to the first shell and the second shell, respectively, such that the conductor 129 extends along the elastic metal wire 121 and is threaded within the first shell and the second shell. For ease of description, the second shell may be the battery shell 123. Further, the battery 14 is arranged in the second shell, and the battery 14 is connected to the flexible circuit board 16 through the conductor 129, i.e., both the battery 14 and the electrode terminal 151 are connected to the flexible circuit board 16 to simplify the alignment. Correspondingly, the flexible cladding layer 128 at least further encapsulates the elastic metal wire 121 and the conductor 129 to allow the conductor 129 to be exposed.

In some embodiments, the shell assembly is applied to the earphone 10 and includes a third shell for accommodating the speaker 112, the third shell being inserted and fixed to the first shell. For ease of description, the third shell may be the core shell 111.

The present disclosure provides a shell assembly, including a first shell, the electrode terminal 151, the microphone 152, and the support assembly 17. The first shell may be provided with an accommodation cavity 124, and the through hole 1251 and the through hole 1253 connected to the accommodation cavity 124, respectively. The through hole 1251 and the through hole 1253 are arranged on different side walls of the first shell, and the electrode terminal 151 is at least partially arranged within the through hole 1251, and the microphone 152 may be provided within the accommodation cavity 124 and pick up sound outside the shell assembly via the through hole 1253. Further, the support assembly 17 may be disposed within the accommodation cavity 124 and may support and fix the electrode terminal 151 and the microphone 152 to side walls corresponding to the through hole 1251 and the through hole 1253, respectively. In this way, it is not only conducive to preventing the electrode terminal 151 and the microphone 152 from separating from the first shell, but also conducive to increasing the waterproof and dustproof performance at the electrode terminal 151 and the microphone 152 with a simple and reliable structure. For ease of description, the first shell may be either the adapter shell 122, the core shell 111, or a shell structure after the core shell 111 and the adapter shell 122 are integrally molded.

In some embodiments, the support assembly 17 is independent of the first shell and inserted within the accommodation cavity 124.

In some embodiments, the support assembly 17 is a one-piece molded structural member.

In some embodiments, the shell assembly is applied to the earphone 10 and includes a third shell for accommodating the speaker 112, the third shell being socketed and fixed to the first shell. The first shell may be the adapter shell 122 and the third shell may be the core shell 111.

Further, the shell assembly may be applied to other electronic devices such as smart glasses in addition to the earphone 10. The electronic device includes the main control circuit board 13, the speaker 112 and the battery 14 connected to the main control circuit board 13, respectively. The shell assembly may be configured to accommodate at least one of the speaker 112, the main control circuit board 13, and battery 14, and may also be used to support the speaker 112 in the electronic device at a corresponding wearing position. It is worth noting that: for electronic devices such as earphones and smart glasses based on the principle of bone conduction, the speaker 112 may be adaptively adapted to be a bone-conduction speaker, and a basic structure of the bone-conduction speaker is well known to those skilled in the art.

For example, in conjunction with FIG. 19, FIG. 4, and FIG. 3, the earphone 10 includes the core module 11 and the hook structure 12 connected to the core module 11, and the core module 11 may be arranged on a front side of the ear in a wearing state, and at least a portion of the hook structure 12 may be located on a rear side of the ear in the wearing state. The core module 11 has an inner side surface IS toward the ear in the wearing state and an outer side surface OS away from the ear along the thickness direction X. The thickness direction X is defined as a direction in which the core module 11 is near or away from the ear in the wearing state. Furthermore, in a non-wearing state and in the thickness direction X, the hook structure 12 extends first toward a side of the inner side surface IS that is back away from the outer side surface OS, and then extends to the other side of the inner side surface IS that is toward the outer side surface OS. Set up in this way, since the hook structure 12 extends the side of the inner side surface IS that is back away from the outer side surface OS in the thickness direction X, a portion of the hook structure 12 may be offset in a direction perpendicular to the thickness direction X relative to a projection of the core module 11, which allows an upper ear root to provide less support to the earphone 10 when worn, thus improving the comfort of the earphone 10 during wear. Moreover, the hook structure 12 extends further towards the side of the inner side surface IS that is toward the outer side surface OS in the thickness direction X, so that the other portion of the hook structure 12 overlaps with the projection of the core module 11 in the direction perpendicular to the thickness direction X, which allows other physiological parts of the ear, besides the upper ear root, to provide more support to the earphone 10 when worn, thereby improving the stability of the earphone 10 during wear. A support force includes a clamping force of the earphone 10 on the ear and a friction force between the earphone 10 and the ear (and its surrounding head). In addition, for embodiments such as an embodiment in which a free end FE of the core module 11 extends into a concha cavity of the ear in the wearing state, such an arrangement is also conducive to the free end FE of the core module 11 extending into the concha cavity in the wearing state.

In some embodiments, the inner side surface IS is provided as a planar surface. In the non-wearing state, the inner side surface IS is on a plane that may intersect with the hook structure 12.

In some embodiments, the clamping force exerted by the hook structure 12 and the core module 11 on the ear in the thickness direction X in the wearing state, for example, the earphone 10 clamping the ear in a left-right direction from the head, may be configured a portion of as the clamping force of the earphone 10 on the ear. The clamping force may be measured through a tensiometer. For example, the earphone 10 is worn on a simulator or the user's ear, i.e., the wearing state; then the tensiometer (e.g., Weiduo WDF-10 digital push-pull tensiometer, which will not be repeated hereinafter) is fixed on a side of the core module 11 away from the ear, and then the tensiometer is pulled and observed. When a side of the core module 11 that is toward the user's ear exactly separates from the ear's skin, a pulling force shown on the tensiometer is read, and the pulling force can be simply regarded as the clamping force.

For example, in conjunction with FIG. 19 and FIG. 9, the hook structure 12 includes the elastic metal wire 121 connected to the core module 11, and at least a portion of the elastic metal wire 121 is arranged on the rear side of the ear in the wearing state, and a plane on which the elastic metal wire 121 is located crossed with the inner side surface IS in the non-wearing state. The elastic metal wire 121 undergoes a certain elastic deformation in the thickness direction X with respect to the core module 11, enabling it to provide a corresponding clamping force. In this way, to allow a portion of the hook structure 12 to overlap with the projection of the core module 11 in the direction perpendicular to the thickness direction X, so that, in the wearing state, the elastic metal wire 121 is elastically deformed and is adhered to the ear together with the core module 11 in the wearing state. It should be noted that: when the hook structure 12 includes a cladding layer such as the flexible cladding layer 128, structural components such as the elastic metal wire 121, the adapter shell 122, and a cover shell 1231 shown in FIG. 9 are not visible in FIG. 19. In some embodiments, the hook structure 12 also does not include the elastic metal wire 121. For example, by using a rigid plastic member in place of the elastic metal wire 121, and based on a material, length, cross-sectional dimension, or the like to design a deformation capacity of the hook structure 12 in various directions, which will not be repeated later.

In some embodiments, in the non-wearing state, the elastic metal wire 121 has an angle between the plane on which the elastic metal wire 121 is located and the inner side surface IS, such as an angle θ formed between a midline ML in FIG. 19 and the inner side surface IS, and the angle is within a range of 15° to 30°. If the angle is too small, it is likely to lead to unstable wearing of the earphone 10 due to insufficient clamping force on the ear. If the angle is too large, it is likely to lead to wearing discomfort of the earphone 10 due to excessive clamping force on the ear. Further, the midline refers to an axis of the elastic metal wire 121.

In some embodiments, a diameter of the elastic metal wire 121 is within a range of 0.6 mm to 0.8 mm. If the diameter is too small, it tends to make it difficult for the elastic metal wire 121 to provide sufficient clamping force, as well as to provide insufficient structural strength. If the diameter is too large, it tends to make it difficult for the elastic metal wire 121 to undergo elastic deformation, as well as providing excessive clamping force.

For example, in conjunction with FIG. 19, FIG. 9, and FIG. 7, the hook structure 12 includes the adapter shell 122 connecting the elastic metal wire 121 and the core module 11, and at least a portion of the adapter shell 122 is located on the front side of the ear in the wearing state, with the adapter shell 122 extending toward the side of the inner side surface IS that is back away the outer side surface OS in the thickness direction X. Such arrangement allows a portion of the hook structure 12 to offset from the projection of the core module 11 in the direction perpendicular to the thickness direction X, and thus, in the wearing state, the upper ear root of the ear can provide less support force on the earphone 10. It is worth noting that when the hook structure 12 includes a cladding layer such as the flexible cladding layer 128, the adapter shell 122 shown in FIG. 9 is not visible in FIG. 19.

For example, in conjunction with FIG. 19 and FIG. 9, the hook structure 12 includes the battery shell 123 connected to an end of the elastic metal wire 121 that is away from the core module 11, and the battery 14 that is arranged in the battery shell 123 coupled to the core module 11, and at least a portion of the battery shell 123 is arranged between the inner side surface IS and the outer side surface OS in the thickness direction X in the non-wearing state. The battery shell 123 is in contact with the rear side of the ear and/or the head in the wearing state.

For example, in combination with FIG. 19 and FIG. 2, the core module 11 has a length direction Y and a width direction Z that are perpendicular to the thickness direction X and orthogonal to each other, and a length of the core module 11 in the length direction Y is greater than a width of the core module 11 in the width direction Z. In the width direction Z, the core module 11 has an upper side surface US that departs from an external ear canal and a lower side surface LS that faces toward the external ear canal in the wearing state, and a rear side surface RS that connects the upper side surface US and the lower side surface LS. The rear side surface RS is located at an end in the length direction Y toward the back of the head in the wearing state. Further, a midline ML of an orthographic projection of the hook structure 12 on a reference plane perpendicular to the width direction Z (e.g., an XY plane in FIG. 19) intersects with an orthogonal projection of the inner side surface IS on the same reference plane to form a first intersection point O1, and the midline ML intersects with an orthographic projection of the rear side surface RS on the same reference plane to form a second intersection point O2. The midline ML passes over a geometric center of a cross-section at any point on the hook structure 12, for example, where the midline ML is the axis of the elastic metal wire 121. It is so set up that, in the case where an orthographic projection of the core module 11 on the reference plane perpendicular to the thickness direction X is a non-circular structure, such as a rounded rectangle, an orthographic projection of the hook structure 12 along the width direction Z falls on the upper side surface US. It is worth noting that: since the core module 11 and the hook structure 12 partially overlap in the width direction Z, a dashed line in FIG. 19 illustrates a portion of the inner side surface IS and the rear side surface RS that is partially obscured by the hook structure 12.

In some embodiments, the first intersection point O1 and the second intersection point O2 are connected to form a first reference line section O1O2, and the first reference line section 0102 has a first component and a second component in the length direction Y and the thickness direction Z, respectively. A ratio between the first component and a length of the core module 11 in the length direction Y may be within a range of 0.12 to 0.19, and a ratio between the second component and a thickness of the core module 11 in the thickness direction X may be within a range of 0.1 and 0.16. This is set up so as to allow for a suitable angle, such as an angle θ between the hook structure 12 and the inner side surface IS, for example, the angle θ is within a range of 15° to 30°, which in turn allows for the earphone 10 to exert a suitable clamping force on the ear.

In some embodiments, a furthest point O3 of the midline ML that is furthest from the inner side surface IS in the thickness direction X is connected to the first intersection point O1 to form a second reference line section 0103. The second reference line section 0103 has a third component and a fourth component in the length direction Y and the thickness direction X, respectively. A ratio between the third component and a length of the core module 11 in the length direction Y may be within a range of 0.43 to 0.66, and a ratio between the fourth component and a thickness of the core module 11 in the thickness direction X may be within a range of 0.26 to 0.4. Such arrangement allows for a suitable angle, such as an angle θ between the hook structure 12 and the inner side surface IS, for example, the angle θ is within a range of 15° to 30°, which in turn allows for the earphone 10 to exert a suitable clamping force on the ear.

For example, in conjunction with FIG. 3, the earphone 10 includes the core module 11 and the hook structure 12 connected to the core module 11. The core module 11 is arranged on the front side of the ear in the wearing state, and the free end FE of the core module 11 that is not connected to the hook structure 12 extends into the concha cavity of the ear in the wearing state, and at least a portion of the hook structure 12 is arranged on the rear side of the ear in the wearing state. The core module 11 and the hook structure 12 jointly clamp the ear from the front side and the rear side of a region corresponding to the concha cavity with a certain clamping force. If the clamping force is too small, it is likely to lead to unstable wearing of the earphone 10. If the clamping force is too large, it is likely to lead to discomfort in wearing the earphone 10.

In some embodiments, in the wearing state, the clamping force exerted by the hook structure 12 and the core module 11 on the ear in the direction perpendicular to the thickness direction X, such as the earphone 10 clamping the ear in a front-rear direction from the head and may be regarded as a portion of the clamping force of the earphone 10 on the ear. The clamping force may be measured through a tensiometer. For example, the earphone 10 is worn on a simulator or the user's ear, i.e., the wearing state; then the tensiometer is fixed on a side of the core module 11 away from the ear, and then the tensiometer is pulled and observed. When a side of the core module 11 that is toward the user's ear exactly separates from the ear's skin, a pulling force shown on the tensiometer is read, and the pulling force can be simply regarded as the clamping force.

In some embodiments, in the non-wearing state, a corresponding measurement can reflect the deformation capacity of the hook structure 12 with respect to the core module 11, which in turn represents the clamping force that the earphone 10 can exert on the ear. A measurement manner is exemplarily described later.

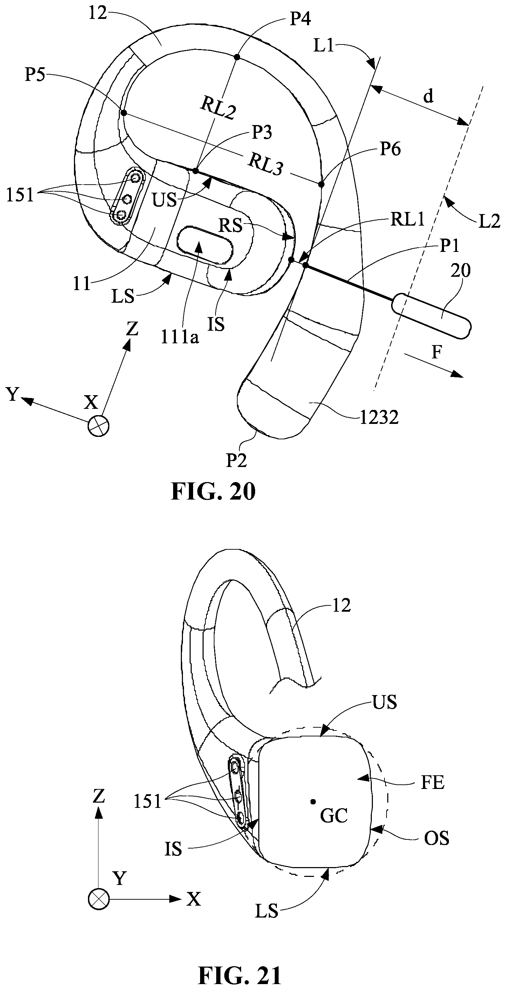

For example, in conjunction with FIG. 20 and FIG. 4, orthographic projections of the hook structure 12 and the core module 11 may not overlap with each other on a first reference plane (e.g., a YZ plane shown in FIG. 20) that is perpendicular to the thickness direction X. The thickness direction X is defined as a direction in which the core module 11 is located near to or away from the ear in the wearing state, which allows the earphone 10 to clamp the ear in a front-and-rear direction. The orthographic projection of the hook structure 12 and the orthographic projection of the core module 11 have a first reference line RL1 with a shortest distance. It should be understood that the orthographic projection of the core module 11 on the reference plane perpendicular to the thickness direction X is a rounded rectangle, an ellipse, a circle, or a rounded square. Furthermore, after the core module 11 is fixed, the hook structure 12, after being pulled away from the core module 11 at a measurement fixed position P1 along a direction parallel to the first reference line RL1 (as indicated by an arrow F in FIG. 20), has a pulling force within a range of 0.6 N to 8 N after being separated from the core module 11 by a distance of 5 mm to 10 mm. The measurement fixation position P1 is defined as being within a range of 16 mm to 27 mm in a length direction of the hook structure 12 (e.g., shown by an arrow L in FIG. 9, and will not be repeated hereinafter) from the free end of the hook structure 12 that is not connected to the core module 11 (e.g., shown by P2 in FIG. 20). Preferably, after the core module 11 has been fixed, the hook structure 12 has a pulling force within a range of 0.8 N to 5 N, after being pulled away from the core module 11 at the measurement fixed position P1 along the direction parallel to the first reference line RL1 by a distance of 5 mm to 10 mm.

Further, after the core module 11 is fixed, the hook structure 12 has a pulling force within a range of 0.1 N to 1.96 N, after being pulled away from the core module 11 at the measurement fixed position P1 in the direction parallel to the first reference line RL1 by a distance of 1 mm and 5 mm.

In some embodiments, the earphone 10 is fixed to a measurement platform in the non-wearing state, such as the core module 11 being fixed to a fixture of a measurement platform. At this point, the first reference line RL1 is parallel to a horizontal plane, and the hook structure 12 is in an overhanging state. Based on this, a tensiometer 20 can be fixed to the hook structure 12, for example, a hook of the tensiometer 20 is hooked or snapped at the measurement fixed position P1, and the measurement fixed position P1 in FIG. 20 is represented as a straight line segment. Subsequently, measuring personnel may manually pull the tensiometer 20 slowly, e.g. so that a displacement of the tensiometer 20 is d, and the hook structure 12 is accordingly deformed from an initial position L1 to a measurement position L2, and record a pulling force F of the displacement. Based on this, at the same measurement fixed position P1, the tensiometer 20 is made to have different amounts of displacement by multiple measurements, and the pulling force F of a corresponding amount of displacement is recorded, thereby reflecting a deformation capacity of the hook structure 12 with respect to the core module 11, and thus representing the clamping force that the earphone 10 can exert on the ear. The tensiometer 20 may also be used as part of a measurement platform that moves the hook structure 12 away from the core module 11 after the earphone 10 has been fixed, i.e., automatic measurement.

In some embodiments, in the non-wearing state, the core module 11 is pressed against an edge of a tabletop, with the hook structure 12 in an overhanging state as much as possible. Similarly, the hook of the tensiometer 20 may be hooked or snapped over the measurement fixed location P1 and measurement can be performed as previously described, and will not be repeated herein.

The following table describes, exemplarily, a correspondence between the pulling force F and a pulling distance d at different measurement fixed positions P1. The unit of the pulling force F is N and the unit of the pulling distance d is mm. Further, in a following table, #1, #2, and #3 denote the measurement fixed position P1 being 16 mm, 21.5 mm, and 27 mm, respectively, in the length direction of the hook structure 12 from the free end of the hook structure 12 that is not connected to the core module 11. It is worth noting that: in order to minimize the measurement error, each pulling force F can be averaged after multiple measurements, such as averaging after three measurements.

| | d=1mm | d=3mm | d=5mm | d=7mm | d=10mm |
|---|---|---|---|---|---|
| #1 | 0.1N | 0.3N | 0.6N | 0.87N | 2.5N |
| #2 | 0.23N | 0.41N | 0.82N | 1.73N | 5N |
| #3 | 0.3N | 0.89N | 1.96N | 3.82N | 8N |

In some embodiments, a length of the first reference line RL1 is within a range of 2 mm to 3 mm. If the length of the first reference line RL1 is too small, it is likely to lead to discomfort in wearing the earphone 10; if the length of the first reference line RL1 is too large, it is likely to lead to instability in wearing the earphone 10.

In some embodiments, a distance between the measurement fixed position P1 and the first reference line RL1 is less than or equal to 1 mm. In such an arrangement, the measurement fixed position P1 can be made as close as possible to a preset position on the hook structure 12 in contact with the ear.

In some embodiments, the core module 11 has a length direction Y and a width direction Z that are perpendicular to the thickness direction X and orthogonal to each other, and a length of the core module 11 in the length direction Y is larger than a length of the core module 11 in the width direction Z. In conjunction with FIG. 21 and FIG. 20, an orthographic projection of the free end FE of the core module 11 on a second reference plane (e.g., an XZ plane in FIG. 21) that is perpendicular to the length direction Y has a geometric center GC, e.g., the geometric center is a center of an outer circle of the orthographic projection. A distance between the measurement fixed position P1 and an extension line that passes through the geometric center GC and is parallel to the first reference line RL1 is less than or equal to 1 mm. In such an arrangement, the measurement fixed position P1 is made as close as possible to the preset position of the hook structure 12 in contact with the ear. For example, in the wearing state, the core module 11 has the inner side surface IS toward the ear and the outer side surface OS back from the ear in the thickness direction X, and the upper side surface US back from the external ear canal and the lower side surface US toward the external ear canal in the width direction Z. The inner side surface IS, the outer side surface OS, the upper side surface US, and the lower side surface LS enclose a geometric figure on the second reference plane, and the geometric center GC is defined as a center of an outer circle of the geometric figure.

For example, in conjunction with FIG. 20, the core module 11 has the length direction Y and the width direction Z that are perpendicular to the thickness direction X and orthogonal to each other, and the length of the core module 11 in the length direction Y is greater than the width of the core module 11 in the width direction Z. In the wearing state, the core module 11 has the upper side surface US back away from the external ear canal and the lower side surface LS toward the external ear canal in the width direction Z. Further, there is a second reference line RL2 with the longest length that is parallel to the width direction Z between the orthographic projection of the hook structure 12 and the orthographic projection of the core module 11, and a length of the second reference line RL2 is within a range of 13 mm to 20 mm. If the length of the second reference line RL2 is too small, it is easy to cause the free end FE of the core module 11 to fail to extend into the concha cavity, and the sound outlet hole 111a on the core module 11 is too far away from the external ear canal; if the length of the second reference line RL2 is too large, it is likewise leading to the free end FE failing to extend into the concha cavity, and the external ear canal being too much obscured by the core module 11. In other words, it is so set up as to allow the free end FE of the core module 11 to extend into the concha cavity, and also to make the sound outlet hole 111a on the core module 11 have a suitable distance from the external ear canal, so that when the external ear canal is not blocked, the user can hear more of sound waves generated by the core module 11.

Further, a direction in which the first reference line RL1 is located is parallel to the length direction Y. In other words, when an orthographic projection of the core module 11 on a reference plane perpendicular to the thickness direction X is set into a rounded rectangle, a distance between the orthographic projection of the hook structure 12 and the orthographic projection of the core module 11 in the length direction Y is minimized.

In some embodiments, a point P3 at which the second reference line RL2 intersects the orthographic projection of the core module 11 is used as a starting point of the second reference line RL2, and a point P4 at which the second reference line RL2 intersects the orthographic projection of the hook structure 12 is used as an end point of the second reference line RL2. A third reference line RL3, which passes through 1/4 of the second reference line RL2 and is parallel to the length direction Y, intersects the hook structure 12 at a first intersection point P5 and a second intersection point P6, respectively. In the length direction Y, the first intersection point P5 on the hook structure 12 is closer to the core module 11 than the second intersection point P6 on the hook structure 12. Furthermore, a distance between the first intersection point P5 and the starting point of the second reference line RL2 is within a range of 9 mm and 15 mm, and a distance between the second intersection point P6 and the starting point of the second reference line RL2 is within a range of 12 mm to 19 mm. In such an arrangement, when the free end FE of the core module 11 extends into the concha cavity and the sound outlet hole 111a on the core module 11 has a suitable distance from the external ear canal, the hook structure 12 and the core module 11 exert a suitable clamping force on the ear.

For example, in conjunction with FIG. 20 and FIG. 9, the hook structure 12 includes the elastic metal wire 121 connected to the core module 11 and the battery shell 123 coupled to an end of the elastic metal wire 121 away from the core module 11. The battery 14 coupled to the core module 11 is arranged in the battery shell 123. The extension line of the first reference line RL1 may pass through the battery shell 123. In such an arrangement, as a portion of the hook structure 12 corresponding to the battery shell 123 is thicker compared to a portion of the hook structure 12 corresponding to the elastic metal wire 121, so that the hook structure 12 clamps the ear through the battery shell 123 together with the core module 11, which is conducive to improving the comfort of the earphone 10 when worn. The elastic metal wire 121 may undergo a certain elastic deformation with respect to the core module 11 in a direction perpendicular to the thickness direction X, so as to provide a corresponding clamping force. It is worth noting that: when the hook structure 12 includes a cladding layer such as the flexible cladding layer 128, structural components such as the elastic metal wire 121, the adapter shell 122, and the cover shell 1231, as shown in FIG. 9, are not visible in FIG. 20.

In some embodiments, the battery shell 123 includes the cover shell 1231 connected to the elastic metal wire 121 and the battery compartment 1232 connected to the cover shell 1231, the battery compartment 1232 and the cover shell 1231 cooperate to form a cavity structure that accommodates the battery 14. The hook structure 12 includes the flexible cladding layer 128 that encapsulates at least the elastic metal wire 121 and the cover shell 1231, and a hardness of the flexible cladding layer 128 may be less than a hardness of the cover shell 1231. Further, the extension line of the first reference line RL1 may pass through a region where the flexible cladding layer 128 overlaps the cover shell 1231. In such an arrangement, the hook structure 12 further clamps the ear with the core module 11 through the flexible cladding layer 128 on the cover shell 1231, which is conducive to further improving the comfort of the earphone 10 when worn.

In some embodiments, the battery compartment 1232 may be provided being open at one end of the hook structure 12 in the length direction, with the cover shell 1231 partially embedded within an open end of the battery compartment 1232. An area of an outer surface of the cover shell 1231 on a reference cross-section perpendicular to the length direction of the hook structure 12 may be smaller than an area of an outer surface of the battery compartment 1232 on the reference cross-section perpendicular to the length direction of the hook structure 12. i.e., an outer diameter of the cover shell 1231 may be smaller than an outer diameter of the battery compartment 1232/ Furthermore, the flexible cladding layer 128 may not encapsulate the battery compartment 1232, and an outer surface of the flexible cladding layer 128 smoothly transitions with the outer surface of the battery compartment 1232 to improve the aesthetic quality of the earphone 10. At this point, the measurement fixed position P1 may be located at a junction between the flexible cladding layer 128 and the battery compartment 1232. In such an arrangement, the measurement fixed position P1 is to be located as close as possible to the preset position of the hook structure 12 in contact with the ear.

For example, in conjunction with FIG. 3 and FIG. 9, the earphone 10 includes the core module 11 and the hook structure 12 connected to the core module 11. The hook structure 12 includes the battery shell 123, with the battery 14 coupled to the core module 11 within the battery shell 123. The core module 11 is arranged on a front side of the ear in the wearing state, and the free end FE of the core module 11 that is not connected to the hook structure 12 extends into the concha cavity of the ear in the wearing state, and at least a portion of the hook structure 12 is arranged on a rear side of the ear in the wearing state. Further, the core module 11 and the battery shell 123 may jointly clamp the ear from s front side and a rear side of a region corresponding to the concha cavity to allow the earphone 10 to be worn stably and comfortably on the ear. The battery shell 123 may also be in contact with the skin of the head around the ear, which is conducive to increasing a contact area between the battery shell 123 and the skin of the user to allow the earphone 10 to be worn stably and comfortably, thereby enhancing the user's wearing experience. In addition to this, due to the increase in the contact area between the earphone 10 in contact with the user's skin, it also helps reduce the risk of the earphone 10 slipping off of the ear when the user lowers, raises, or shakes head.

In some embodiments, a maximum area of the outer surface of the battery shell 123 on the reference cross-section perpendicular to the length direction of the hook structure 12 may be within a range of 60 mm² to 100 mm². If the maximum area is too small, it is likely to result in difficulty for the battery shell 123 to come into contact with the skin of the head around the ear, as well as difficulty for the battery 14 to satisfy an endurance requirement of earphone 10 due to insufficient capacity; if the maximum area is too large, it is likely to result in the battery shell 123 being overly visible from a front side of the ear, which in turn affects the aesthetic quality of the earphone 10 in the wearing state.

For example, in conjunction with FIG. 9, the battery shell 123 includes the cover shell 1231 and the battery compartment 1232 connected to the cover shell 1231. The battery compartment 1232 may be provided being open at one end in the length direction of the hook structure 12, and the cover shell 1231 may be partially embedded within an open end of the battery compartment 1232 to cooperate in forming a cavity structure for accommodating the battery 14. An area of the outer surface of the cover shell 1231 on the reference cross-section perpendicular to the length direction of the hook structure 12 gradually increases in a positive direction that is along the length direction of the hook structure 12 and close to the battery compartment 1232, i.e., the hook structure 12 may be set into a tapering structure at the cover shell 1231, which is conducive to alleviating a difference in outer diameter between the battery compartment 1232 and other portions (e.g., the elastic metal wire 121) of the hook structure 12), thereby making the hook structure 12 smoother and more proportional in overall appearance. Further, the cover shell 1231 may be in contact with the ear as described above to clamp the ear with the core module 11, and the battery compartment 1232 may be in contact with the skin of the head around the ear to increase the contact area between the battery shell 123 and the user's skin. In other words, different portions of the battery shell 123 are in contact with the skin at different physiological locations.

In some embodiments, a contact area between the cover shell 1231 and the skin of the head around the ear may be less than a contact area between the battery compartment 1232 and the skin of the head around the ear, so that when the cover shell 1231 clamps the ear together with the core module 11, the cover shell 1231 does not need to take into account the contact between the battery compartment 123 and the skin of the head around the ear too much. In other words, different portions of the battery shell 123 can have different design intentions. As a result, the cover shell 1231 and the skin of the head around the ear can be out of contact.

In some embodiments, the hook structure 12 includes the elastic metal wire 121 connecting the core module 11 and the cover shell 1231, and the flexible cladding layer 128 encapsulating at least the elastic metal wire 121 and the cover shell 1231. The cover shell 1231 may be in contact with the ear through the flexible cladding layer 128 to improve the comfort of the earphone 10 when worn. The flexible cladding layer 128 may not encapsulate the battery compartment 1232, which helps to reduce the risk of the hook structure 12 being exposed too much from the front side of the ear due to the battery compartment 1232 being too thick at the battery compartment 1232, and thus improves the appearance quality of the earphone 10 in the wearing state. Furthermore, an outer surface of the flexible cladding layer 128 may smoothly transition with the outer surface of the battery compartment 1232 to improve the aesthetic quality of the earphone 10 in the non-wearing state.

In some embodiments, the core module 11 has the inner side surface IS toward the ear and the outer side surface OS away from the ear in the thickness direction X in the wearing state, the thickness direction X is defined as a direction in which the core module 11 is near or away from the ear in the wearing state. At least a portion of the battery shell 123 is located between the inner side surface IS and the outer side surface OS in the thickness direction X in the non-wearing state so that the clamping force of the earphone 10 on the ear is mainly expressed as a positive pressure, thus improving the comfort of the earphone 10 when worn. Further, the core module 11 has a length direction Y and a width direction Z that are perpendicular to the thickness direction X and orthogonal to each other, and a length of the core module 11 in the length direction Y may be greater than a width of the core module 11 in the width direction Z. An orthographic projection of the cover shell 1231 along the length direction Y and a orthographic projection of the core module 11 along the length direction Y may at least partially overlap, an orthographic projection of the battery compartment 1232 along the length direction Y and the orthographic projection of the core module 11 along the length direction Y may at least partially not overlap, which allows the hook structure 12 to clamp the ear primarily at the cover shell 1231 together with the core module 11.

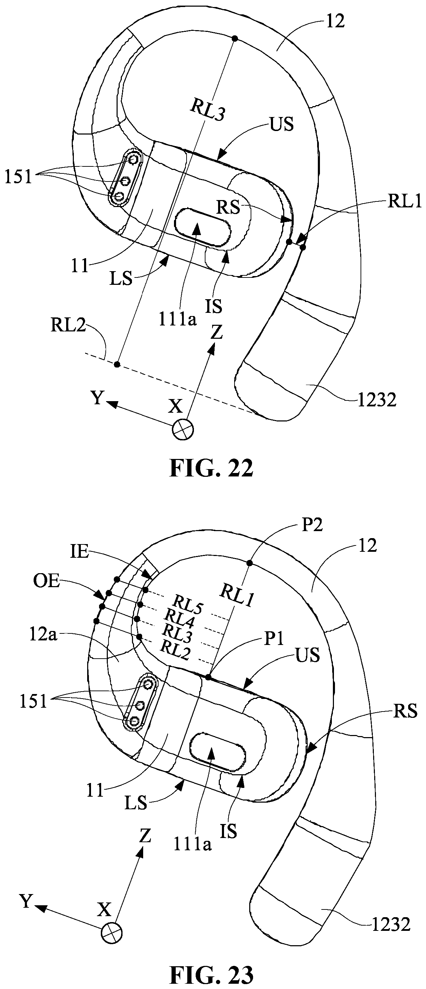

For example, in conjunction with FIG. 22, FIG. 9, and FIG. 3, the earphone 10 includes the core module 11 and the hook structure 12 connected to the core module 11. The core module 11 may be arranged on the front side of the ear in the wearing state, and at least a portion of the hook structure 12 may be arranged on the rear side of the ear in the wearing state. Orthographic projections of the hook structure 12 and the core module 11 on a reference plane (e.g., a YZ plane of FIG. 22) perpendicular to the thickness direction X may not overlap, with the thickness direction X being defined as a direction in which the core module 11 is located near to or away from the ear in the wearing state. Further, the hook structure 12 includes the battery shell 123 and the flexible cladding layer 128. The battery 14 coupled to the core module 11 is arranged in the battery shell 123, and the battery shell 123 includes the cover shell 1231 and the battery compartment connected to the cover shell 1231, and flexible cladding layer 128 encapsulates the cover shell 1231. There is a first reference line RL1 with the shortest distance between the orthographic projection of the hook structure 12 and the orthographic projection of the core module 11, and a point where the first reference line RL1 intersects the orthographic projection of the hook structure 12 may be located in a region where the flexible cladding layer 128 overlaps the cover shell 1231. In other words, the hook structure 12 contacts the rear side of the ear through the cover shell 1231 and the flexible cladding layer 128 thereon, thereby clamping the ear together with the core module 11, which improves the comfort of the earphone 10. It should be noted that the orthographic projection of the core module 11 on the reference plane perpendicular to the thickness direction X may be a rounded rectangle, an ellipse, a circle, or a rounded square.

In some embodiments, the clamping force exerted by the hook structure 12 and the core module 11 on the ear in the thickness direction X in the wearing state, e.g., the earphone 10 clamping the ear in a left-right direction from the head, may be regarded as a portion of the clamping force of the earphone 10 on the ear.

In some embodiments, in the wearing state, a clamping force exerted by the hook structure 12 and the core module 11 on the ear in a direction perpendicular to the thickness direction X, such as the earphone 10 clamping the ear in a front-rear direction from the head, may be regarded a portion of the clamping force on the ear.

In some embodiments, in the non-wearing state, the earphone 10 has a second reference line RL2 parallel to the first reference line RL1 on the reference plane (e.g., the YZ plane of FIG. 22) perpendicular to the thickness direction X. The second reference line RL2 intersects with the orthographic projection of the battery shell 123 and is furthest away from the first reference line RL1. Based on this, there is a maximum distance between an edge of the orthographic projection of the hook structure 12 toward the core module 11 and the second reference line RL2, such as a length of the third reference line RL3 in FIG. 22, and the maximum distance may be within a range of 34 mm to 52 mm. If the maximum distance is too small, it is likely to lead to a capacity of the battery 14 being insufficient to satisfy the endurance requirement of the earphone 10; and if the maximum distance is too large, it not only increases the likelihood of the hook structure 12 being overly visible from the front of the ear due to the battery shell 123 being too long, thus affecting the aesthetic quality of the earphone 10 when worn, but it also increases the risk of interference between the hook structure 12 and the user's earlobe or nearby earrings, especially for female users, which may negatively impact the user's overall satisfaction.

In some embodiments, a distance between the free end of the hook structure 12 that is not connected to the core module 11 and an upper ear root of the ear in a vertical axis of the human body (e.g., as shown in V1 in FIG. 3) is within a range of 37 mm to 56 mm in the wearing state. If the distance is too small, it is likely to result in the capacity of the battery 14 being insufficient to meet the endurance requirement of the earphone 10; if the distance is too large, it not only increases the likelihood of the hook structure 12 being overly visible from the front of the ear due to the battery shell 123 being too long, thus affecting the aesthetic quality of the earphone 10 when worn, but it also increases the risk of interference between the hook structure 12 and the user's earlobe or nearby earrings, especially for female users, which may negatively impact the user's overall satisfaction.

In some embodiments, a distance between the free end of the hook structure 12 that is not connected to the core module 11 and an edge of an earlobe in the vertical axis of the human body (e.g., as shown in V2 in FIG. 3) is less than or equal to 10 mm in the wearing state. If the distance is too large, it is easy to lead to insufficient capacity of the battery 14 to satisfy the endurance requirement of the earphone 10.

In some embodiments, a length of the battery compartment 1232 in the length direction of the hook structure 12 is within a range of 10mm to 20mm. This setup strikes a balance between the battery life of the earphone 10 and its aesthetic quality when worn.

In some embodiments, the battery compartment 1232 is provided in a hollow cylindrical shape, and the area of the outer surface of the battery compartment 1232 on the reference cross-section perpendicular to the length direction of the hook structure 12 is within a range of 60 mm² to 100 mm². If the area is too small, it is likely to result in the capacity of the battery 14 being insufficient to satisfy the endurance requirement of the earphone 10; and if the area is too large, it is likely to result in the battery shell 123 being overly visible from the front side of the ear, thereby affecting the aesthetic quality of the earphone 10 in the wearing state.

For example, in conjunction with FIG. 3 and FIG. 1, the earphone 10 includes the core module 11 and the hook structure 12 connected to the core module 11. The core module 11 is arranged on the front side of the ear in the wearing state, and the free end FE of the core module 11 that is not connected to the hook structure 12 extends into the concha cavity of the ear in the wearing state, and at least a portion of the hook structure 12 is arranged on the rear side of the ear in the wearing state. The core module 11 has a thickness direction X, a length direction Y, and a width direction Z that are orthogonal to each other, the thickness direction X being defined as a direction in which the core module 11 is close to or far away from the ear in the wearing state, and a length of the core module 11 in the length direction Y may be greater than a width of the core module 11 in the width direction Z. Further, the length of the core module 11 in the length direction Y (e.g., shown as L in FIG. 3) is within a range of 22 mm to 35 mm. If the length of the core module 11 is too small, it is easy to cause the free end FE of the core module 11 to be difficult to extend into the concha cavity, and it is also difficult to further clamp the ear together with the hook structure 12; if the length of the core module 11 is too large, it is likely to cause the free end FE of the core module 11 to be difficult to extend into the concha cavity, or even to affect the wearing of the earphone 10. Further, the hook structure 12 has a transition portion 12a connected to the core module 11. The transition portion 12a is arranged on the front side of the ear in the wearing state, and an area of an outer surface of the transition portion 12a on the reference cross-section perpendicular to the length direction of the hook structure 12 gradually decreases in the length direction of the hook structure 12, moving away from the position projection of the core module 11, i.e., the transition portion 12a may be set into a tapering structure to make the earphone 10 smoother and more proportional in overall appearance. Based on this, in the wearing state and viewed along a direction where the coronal axis of the human body is located, compared to the free end FE of the core module 11 that is not connected to the hook structure 12, the connection end CE of the core module 11 that is connected to the hook structure 12 is closer to the top of the head of the user, and an angle between the length direction Y and a direction where the sagittal axis of the human body is located (e.g., as shown by θ in FIG. 3) is within a range of 15° to 60°, so as to allow the transition portion 12a crosses a recessed region 109 between a helix and a tragus located in the ear as much as possible, which is conducive to reducing the risk of the transition portion 12a interfering with the user's skin too much, and thus improving the comfort of the earphone 10 when worn.

In some embodiments, such as FIG. 7, the hook structure 12 and the core module 11 are fixed through insertion in a direction perpendicular to the width direction Z. Based on this, the length of the core module 11 in the length direction Y can be measured after the core module 11 is disassembled from the hook structure 12.

In some embodiments, the width of the core module 11 in the width direction Z (e.g., shown as W in FIG. 3) is within a range of 10 mm to 16 mm. If the width of the core module 11 is too small, it is likely to cause the core module 11 to cause wearing discomfort due to a contact area of the core module 11 in contact with the ear being too small; and if the width of the core module 11 is too large, it is likely to cause the core module 11 to overly obscure the external ear canal.

Exemplarily, in conjunction with FIG. 23, there is a first reference line RL1 with the longest distance that is parallel to the width direction Z between an edge of an orthographic projection of the hook structure 12 toward the core module 11 on the reference plane perpendicular to the thickness direction X (e.g., the YZ plane shown in FIG. 23) and the orthographic projection of the core module 11 on the same reference plane. A point P1 at which the first reference line RL1 intersects the orthographic projection of the core module 11 is a starting point of the first reference line RL1, and a point P2 at which the first reference line RL1 intersects the orthographic projection of the hook structure 12 is an end point of the first reference line RL1. Furthermore, an orthographic projection of the transition portion 12a has an inner edge IE and an outer edge OE that are in successive arcuate transitions, respectively, the outer edge OE being further away from the first reference line RL1 than the inner edge IE in the length direction Y. An overall curvature of the inner edge IE may be greater than an overall curvature of the outer edge OE to make the transition portion 12a smoother and more proportional in overall appearance.

In some embodiments, the orthographic projection of the transition portion 12a has a second reference line RL2, a third reference line RL3, a fourth reference line RL4, and a fifth reference line RL5 that are parallel in the length direction Y and spaced apart. The second reference line RL2, the third reference line RL3, the fourth reference line RL4, and the fifth reference line RL5 are sequentially further away from the orthographic projection of the core module 11 in the width direction Z. Furthermore, the second reference line RL2, the third reference line RL3, the fourth reference line RL4, and the fifth reference line RL5 have their starting points and end points falling on the inner edge IE and the outer edge OE, respectively. A length of the second reference line RL2 may be within a range of 5 mm to 8 mm, and an extension line of the second reference line RL2 passes 1/8 of the first reference line RL 1; a length of the third reference line RL3 is within a range of 4 mm to 6.3 mm, and an extension line of the third reference line RL3 passes 1/4 of the first reference line RL1; a length of the fourth reference line RL4 is within a range of 3.5 mm to 5.4 mm, and an extension line of the fourth reference line RL4 passes 3/8 of the first reference line RL1; and a length of the fifth reference line RL5 is within a range of 3 mm to 5 mm, and an extension line of the fifth reference line RL5 passes 1/2 of the first reference line RL1.

In some embodiments, the length of the first reference line RL1 is within a range of 13 mm to 20 mm. If the length of the first reference line RL1 is too small, it is likely to result in the free end FE of the core module 11 failing to extend into the concha cavity, and the sound outlet hole 111a on the core module 11 being too far away from the external ear canal; if the length of the first reference line RL1 is too large, it is likewise likely to result in the free end FE failing to extend into the concha cavity, and the external ear canal being too much obscured by the core module 11. In other words, it is so set up as to allow the free end FE of the core module 11 to extend into the concha cavity, and also to make the sound outlet hole 111a on the core module 11 have a suitable distance from the external ear canal, so that the user can hear more of the sound waves generated by the core module 11 when the external ear canal is not blocked.

In some embodiments, the hook structure 12 includes the adapter shell 122 connected to the core module 11 and the elastic metal wire 121 connected to the adapter shell 122, and at least a portion of the adapter shell 122 is arranged on the front side of the ear in the wearing state, and at least a portion of the elastic metal wire 121 is arranged on the rear side of the ear in the wearing state. In other words, the portion of the adapter shell 122 that is arranged on the front side of the ear in the wearing state may serve as a portion of the transition portion 12a or all of the transition portion 12a. In this regard, in the wearing state, the core module 11 has the inner side surface IS toward the ear and the outer side surface OS back away from the ear in the thickness direction X, and an area of an outer surface of the adapter shell 122 on the reference cross-section perpendicular to the length direction of the hook structure 12 may gradually decrease in the length direction of the hook structure 12, moving away from positive projection of the core module 11, which allows the transition portion 12a to be set into a tapering structure. Furthermore, the adapter shell 122 extends in the thickness direction X toward a side of the inner side surface IS that is away from the outer side surface OS, which allows a portion of the hook structure 12 to staggered from a projection of the core module 11 in a direction perpendicular to the thickness direction X, and thus in the wearing state, the upper ear root can provide less support to the earphone 10. a plane where the elastic metal wire 121 is located and the inner side surface IS can cross in the non-wearing state, which allows a portion of the hook structure 12 to overlap with the projection of the core module 11 in the direction perpendicular to the thickness direction X, and thus in the wearing state, the elastic metal wire 121 can clamp the ear together with the core module 11 due to elastic deformation and adhere to the ear.

For example, in conjunction with FIG. 7 and FIG. 3, the earphone 10 includes the core module 11 and the hook structure 12 connected to the core module 11. The core module 11 is arranged on the front side of the ear in the wearing state, and the free end FE of the core module 11 that is not connected to the hook structure 12 extends into the concha cavity of the ear in the wearing state, and at least a portion of the hook structure 12 is arranged on the rear side of the ear in the wearing state. In the wearing state, the core module 11 has a first inner side surface IS1 toward the ear and an outer side OS surface back away from the ear in the thickness direction X, the thickness direction X being defined as a direction in which the core module 11 is close to away from the ear in the wearing state. The hook structure 12 has the transition portion 12a connected to the core module 11, the transition portion 12a is arranged on the front side of the ear in the wearing state, and has a second inner side surface IS2 toward the ear in the thickness direction X in the wearing state. Further, the first inner side surface IS1 covers at least a portion of the tragus in the wearing state, and the second inner side surface IS2 is bent in the thickness direction X with respect to the first inner side surface IS1 in a direction away from the outer side surface OS, such as the portion of the hook structure 12 arranged on the front side of the ear in the wearing state is bent with respect to the core module 11. In this way, even if the earphone 10 has to cross the tragus, a space for the tragus may be formed between the hook structure 12 and the core module 11, i.e., the earphone 10 can avoid the tragus, which is conducive to reducing the risk of the earphone 10 compressing the ear screen, which in turn improves the comfort of the earphone 10 in the wearing state.

In some embodiments, an angle between the second inner side surface IS2 and the first inner side surface IS1 is within a range of 119° to 170°. If the angle is too small, it is likely to violate the design intent of the earphone 10, i.e., to avoid the tragus; if the angle is too large, it is likely to result in the earphone 10 being less closely adhered to the user's skin in the wearing state.

In some embodiments, a distance between an end of the second inner side surface IS2 away from the core module 11 and the first inner side surface IS1 in the thickness direction X is within a range of 1.6 mm to 2.4 mm. If the distance is too small, it is likely to violate the design intent of the earphone 10, i.e., avoids the tragus; and if the distance is too large, it is likely to result in the earphone 10 being less closely adherent to the skin of the user in the wearing state.

For example, the transition portion 12a includes the adapter shell 122 connected to the core module 11, and at least a portion of the adapter shell 122 is arranged on the front side of the ear in the wearing state. In other words, the portion of the adapter shell 122 that is arranged on the front side of the ear in the wearing state serves as a portion of the transition portion 12a or all of the transition portion 12a. In this regard, the adapter shell 122 is provided to be a tapering structure, such that an area of an outer surface of the adapter shell 122 on the reference cross-section perpendicular to the length direction of the hook structure 12 becomes gradually smaller in the length direction of the hook structure 12, moving away from the positive direction of the core module 11. Set up in this way, the transition portion 12a may also be set up as a tapering structure to make the earphone 10 smoother and more proportional in overall appearance.

Furthermore, in the thickness direction, the adapter shell 122 extends toward the side of the first inner side surface IS1 that is back from the outer side surface OS to allow the earphone 10 to avoid the tragus in the wearing state, as well as to allow a portion of the hook structure 12 to be offset from the projection of the core module 11 in the direction perpendicular to the thickness direction X, which in turn allows the upper ear root to provide less support to the earphone 10 in the wearing state.

In some embodiments, in the non-wearing state, the elastic metal wire 121 passes through a plane where the first inner side surface IS1 is located to allow a portion of the hook structure 12 to overlap with the projection of the core module 11 in the direction perpendicular to the thickness direction X, and the elastic metal wire 121. In turn, in the wearing state, the elastic metal wire 121 clamps the ear together with the core module 11 and adheres to the ear due to elastic deformation.

In some embodiments, in the non-wearing state, the plane on which the elastic metal wire 121 is located and the first inner surface IS1 crosses to allow a portion of the hook structure 12 to overlap with the projection of the core module 11 in the direction perpendicular to the thickness direction X. In turn, the core module 11 clamps the ear together with the core module 11 and adheres to the ear due to elastic deformation in the wearing state. In the non-wearing state, an angle between the elastic metal wire 121 and the first inner side surface IS1 is within a range of 15° to 30°.

In some embodiments, the core shell 111 includes the core inner shell 1111 and the core outer shell 1112 connected to the core inner shell 1111, such as the two being snapped together in the thickness direction X. The core inner shell 1111 may be closer to the ear in the wearing state compared to the core outer shell 1112, and the sound outlet hole 111a may be provided on the core inner shell 1111. Further, at least one of the core inner shell 1111 and the core outer shell 1112 may be inserted and fixed with the adapter shell 122, such as the core inner shell 1111 shown in FIG. 7 is inserted and fixed with the adapter shell 122.

In some embodiments, the core shell 111 includes the core inner shell 1111 and the core outer shell 1112 connected to the core inner shell 1111, such as the two being snapped together in the thickness direction X. The core inner shell 1111 may be closer to the ear in a wearing state compared to the core outer shell 1112, and the sound outlet hole 111a may be provided on the core inner shell 1111. Furthermore, one of the core inner shell 1111 and the core outer shell 1112 may be provided as a one-piece structural member with the adapter shell 122, and the other is fixedly connected to the one-piece structural member. Based on this, for the one-piece structural member, a region corresponding to the speaker 112 can be simply regarded as the core inner shell 1111, and a region provided in a tapering structure or a region corresponding to the electronic element 15 can be simply regarded as the adapter shell 122.

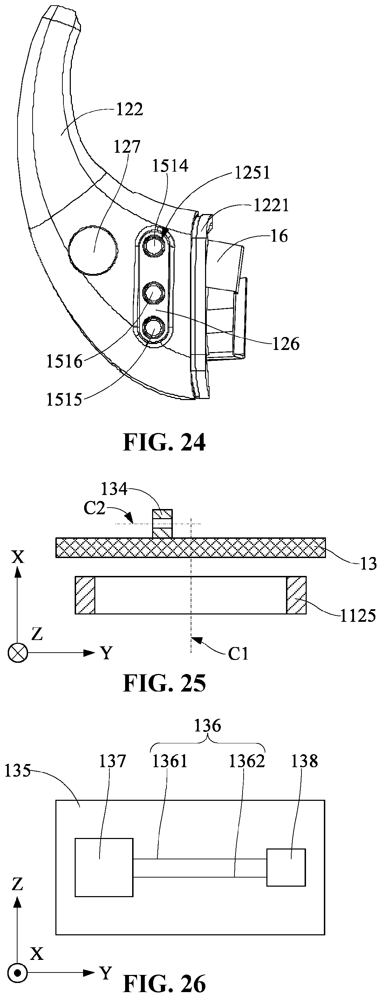

For example, in conjunction with FIG. 7 and FIG. 3, the earphone 10 includes the core module 11 and the hook structure 12 connected to the core module 11. The core module 11 is arranged on the front side of the ear in the wearing state, and at least a portion of the hook structure 12 is arranged on the rear side of the ear in the wearing state. The core module 11 includes the core shell 111 and the speaker 112 arranged in the core shell 111. The hook structure 12 includes the adapter shell 122 connected to the core shell 111. At least a portion of the adapter shell 122 is arranged on the front side of the ear in the wearing state. Further, in combination with FIG. 24, FIG. 15, and FIG. 16, the adapter shell 122 forms the accommodation cavity 124 and the through hole 1251 in communication with the accommodation cavity 124. The earphone 10 includes the electrode terminal 151 at least partially arranged in the through hole 1251. As the adapter shell 122 forms the accommodation cavity 124, some components may be accommodated in the accommodation cavity 124, which is favorable to saving the space of the core module 11 to allow the speaker 112 to be as large as possible. Moreover, the electrode terminal 151 may be provided on the adapter shell 122, which is conducive to shortening a distance between the electrode terminal 151 and the speaker 112 in the length direction of the hook structure 12, so that a magnetic suction force between a magnetic circuit system of the speaker 112 (which includes a magnet) and a magnetic suction structure in a charging case can be fully utilized, to make the electrode terminal 151 more reliably contacting electrode terminals in the charging case.

In some embodiments, the electrode terminal 151 is oriented toward the front side of the ear in the wearing state, such that the electrode terminal is closer 151 to the speaker 112, which is conducive to further shortening the distance between the electrode terminal 151 and the speaker 112 in the length direction of the hook structure 12.

In some embodiments, the electrode terminal 151 includes the charging positive terminal 1514 and the charging negative terminal 1515 spaced apart from each other. The charging positive terminal 1514 and the charging negative terminal 1515 are arranged within a respective through hole 1251 to facilitate charging of the earphone 10 through the electrode terminal 151.

In some embodiments, the electrode terminal 151 includes a communication terminal 1516 between the charging positive terminal 1514 and the charging negative terminal 1515. The communication terminal 1516 is arranged in a corresponding through hole 1251 to facilitate communication and connection of the earphone 10 to a charging device such as a charging case.

For example, in conjunction with FIG. 24, a distance between the charging positive terminal 1514 and the charging negative terminal 1515 is greater than a distance between the charging positive terminal 1514 and the communication terminal 1516, and the distance between the charging positive terminal 1514 and the communication terminal 1516 is greater than a distance between the communication terminal 1516 and the charging negative terminal 1515. A potential of the charging positive terminal 1514 is generally higher than a potential of the communication terminal 1516, and the communication terminal 1516 is generally more susceptible to damage from high voltage. In order to minimize or avoid the probability of damage to the communication terminal 1516 due to conduction between the charging positive terminal 1514 and the communication terminal 1516 in a limited space, the distance between the charging positive terminal 1514 and the communication terminal 1516 is larger than the distance between the communication terminal 1516 and the charging negative terminal 1515. And, in order to avoid or reduce the probability of damage to the earphone 10 due to a short circuit between the charging positive terminal 1514 and the charging negative terminal 1515, the distance between the charging positive terminal 1514 and the charging negative terminal 1515 is larger compared to the distance between the communication terminal 1516 and the charging negative terminal 1515. Further, in some embodiments, the distance between the charging positive terminal 1514 and the charging negative terminal 1515 is greater than the distance between the charging positive terminal 1514 and the communication terminal 1516, to cluster the electrode terminal 151 be set as centrally as possible to reduce the space occupied by the electrode terminal 151 while minimizing the risk of a short circuit of the electrode terminal 151 and minimizing damage to the earphone 10.

In some embodiments, when viewed along an extension direction of the electrode terminal 151 lines connecting the charging positive terminal 1514, the charging negative terminal 1515, and the communication terminal 1516 two-by-two form an unequal triangle.

In some embodiments, the charging positive terminal 1514, the communication terminal 1516, and the charging negative terminal 1515 are spaced apart from each other and arranged in a line segment, such as sequentially aligned in a straight line segment. When viewed along the extension direction of the electrode terminal 151, the magnet 127 and the core module 11 are located on two sides of the straight line segment, respectively. Set up in this way, when the earphone 10 is placed in a charging case, a magnetic circuit system of the speaker 112 forms a first magnetic attraction pair with a permanent magnet or a soft magnet inside the charging case, and the magnet 127 forms a second magnetic attraction pair with another permanent magnet or soft magnet inside the charging case, and the electrode terminal 151 is thus located between the first magnetic attraction pair and the second magnetic attraction pair to more reliably contact electrode terminals in the charging case. Furthermore, the area of the outer surface of the adapter shell 122 on the reference cross-section perpendicular to the length direction of the hook structure 12 may be gradually reduced in the length direction of the hook structure 12, moving away from the positive projection of the core module 11, i.e., the adapter shell 122 may be set into a tapering structure to allow the transition portion 12a of the hook structure 12 to be set into a tapering structure, so that the earphone 10 is smoother and more proportional in overall appearance. The magnet 127 has a first distance, a second distance, and a third distance between a center of the magnet 127 and a center of the charging positive terminal 1514, the center of the magnet 127 and a center of the communication terminal 1516, and the center of the magnet 127 and a center of the charging negative terminal 1515, respectively. The third distance may be greater than the first distance and the second distance, respectively, which is conducive to reducing the risk that a wall of the adapter shell 122 is too thin since the magnet 127 is too close to the charging negative terminal 1515, thereby increasing a structural strength of the adapter shell 122.

For example, in conjunction with FIG. 7 and FIG. 24, in the wearing state, the core shell 111 has the first inner side surface IS1 toward the ear and an outer side surface OS back away from the ear in the thickness direction X, with the thickness direction X being defined as a direction in which the core module 11 is close to or far away from the ear in the wearing state. The adapter shell 122 has a second inner side toward the ear in the wearing state along the thickness direction X ( For example, the second inner side surface IS2 of the transition portion 12a). The second inner side surface IS2 is bent in the thickness direction X with respect to the first inner side surface IS1 in a direction away from the outer side surface OS, for example, the adapter shell 122 is bent with respect to the core module 11. Further, the electrode terminal 151 is exposed on the second inner side surface IS2 to facilitate contact with the electrode terminals in the charging case, and the extension direction of the electrode terminal 151 may cross a winding direction (e.g., as shown by C1 in FIG. 25) of a coil of the speaker 112 (i.e., the voice coil mentioned above). This is set up so that a suction direction of the first magnetic suction pair intersects with a suction direction of the second magnetic suction pair, which is conducive to lowering the risk of the earphone 10 wobbling inside the charging case and allowing the electrode terminal151 to more reliably contact the electrode terminals inside the charging case.

Further, the core module 11 includes the main control circuit board 13 arranged in the core shell 111 and coupled to the speaker 112. The main control circuit board 13 and the speaker 112 are stacked in the thickness direction X and arranged on a side of the speaker that is toward the outer side surface OS. Set up in this manner, it is advantageous to increase an area of the speaker 112 when the core shell 111 has a limited size on the reference cross-section perpendicular to the thickness direction X, as well as to enable the speaker 112 to be closer to the permanent magnet or soft magnet in the charging case, thereby increasing a magnitude of the suction force of the first magnetic suction pair, and making the electrode terminal 151 more reliably contact the electrode terminals in the charging case.

Based on the foregoing descriptions in relation thereto, the earphone 10 includes the charging positive terminal 1514, the charging negative terminal 1515, and the communication terminal 1516 spaced apart from each other, and the charging positive terminal 1514, the charging negative terminal 1515, and the communication terminal 1516 may be arranged on a same side of the ear in the wearing state, such as all three being arranged on the front side of the ear. The distance between the charging positive terminal 1514 and the charging negative terminal 1515 may be greater than the distance between the charging positive terminal 1514 and the communication terminal 1516, the distance between the charging positive terminal 1514 and the communication terminal 1516 may be greater than the distance between the communication terminal 1516 and the charging negative terminal 1515. The potential of the charging positive terminal 1514 is generally higher than the potential of the communication terminal 1516, and the communication terminal 1516 is generally more susceptible to damage from high voltage. In order to minimize the probability of damage to the communication terminal 1516 due to conduction between the charging positive terminal 1514 and the communication terminal 1516 in a limited space, the distance between the charging positive terminal 1514 and the communication terminal 1516 is larger than the distance between the communication terminal 1516 and the charging negative terminal 1515. In order to avoid or reduce the probability of damage to the earphone 10 due to a short circuit between the charging positive terminal 1514 and the charging negative terminal 1515, the distance between the charging positive terminal 1514 and the charging negative terminal 1515 may also be larger compared to the distance between the communication terminal 1516 and the charging negative terminal 1515. Further, in some embodiments, the distance between the charging positive terminal 1514 and the charging negative terminal 1515 is greater than the distance between the charging positive terminal 1514 and the communication terminal 1516, so as to cluster the electrode terminal 151 be set as centrally as possible to reduce the space occupied by the electrode terminal 151, thereby minimizing the risk of a short circuit between the electrode terminal 151 and minimizing damage to the earphone 10.

In some embodiments, at least one of the charging positive terminal 1514, the charging negative terminal 1515, and the communication terminal 1516 is arranged on the adapter shell 122, such as all three are arranged on the adapter shell 122, or, such as all three are arranged on the battery shell 123.

In some embodiments, at least one of the charging positive terminal 1514, the charging negative terminal 1515, and the communication terminal 1516 is arranged on the core shell 111, e.g., any one of the three is arranged on the core shell 111 and the remaining two are arranged on the adapter shell 122.

For example, in conjunction with FIG. 25 and FIG. 7, the core module 11 includes the core shell 111, the speaker 112 and the main control circuit board 13 arranged in the core shell 111. The speaker 112 is electrically connected to the main control circuit board 13. The main control circuit board 13 is configured to process a signal and transmit a processed electrical signal to the speaker 112, and the speaker 112 is configured to convert a received electrical signal into a mechanical vibration. The speaker 112 includes a first coil 1125 (i.e., the voice coil mentioned above) coupled to the main control circuit board 13, and the first coil 1125 may extend into a magnetic circuit system of the speaker 112. A second coil 134 may be arranged on the main control circuit board 13. Further, a winding axis direction of the second coil 134 (e.g., shown as C2 in FIG. 25) and a winding axis direction of the first coil 1125 (e.g., shown as C1 in FIG. 25) may be crossed. This setup helps to reduce the mutual inductive coupling between the second coil 134 and the first coil 1125, thereby minimizing the interaction between the two coils. For example, it reduces the risk of noise such as 'hissing' or 'squealing' caused by the current variation in the second coil 134 being coupled to the speaker 112 through mutual inductance. As the mutual inductive coupling between the first coil 1125 and the second coil 134 is reduced, it allows the main control circuit board 13 to be closer to the speaker 112, which facilitates a more compact structure of the core module 11.

In some embodiments, the main control circuit board 13 and the speaker 112 are stacked in the winding axis of the first coil 1125. Such an arrangement facilitates the provision of a larger speaker 112 in the core shell 111 when the volume of the core shell 111 is certain, thereby increasing the sensitivity and maximum volume of the earphone 10. The winding axial direction of the second coil 134 and the winding axial direction of the first coil 1125 may be set orthogonally, for example, the winding axial direction of the second coil 134 and the winding axial direction of the first coil 1125 are parallel, respectively, to the length direction Y and the thickness direction X, so as to further weaken the mutual inductive coupling between the second coil 134 and the first coil 1125. Furthermore, due to the weakening of the mutual inductive coupling between the second coil 134 and the first coil 1125, a distance between the main control circuit board 13 and the speaker 112 in the winding axial direction of the first coil 1125 may be further reduced, thereby facilitating the core module 11 to be set more compactly in the thickness direction X and reducing the volume of the core module 11. In some embodiments, the distance between the main control circuit board 13 and the speaker 112 in the winding axis direction of the first coil 1125 may be less than or equal to 3 mm. The second coil 134 may be arranged on one side of the main control circuit board 13 back from the speaker 112 or on the other side of the main control circuit board 13 toward the speaker 112. For example, the second coil 134 is arranged on one side of the main control circuit board 13 that is back away from the speaker 112, and the distance between the main control circuit board 13 and the speaker 112 in the winding axis direction of the first coil 1125 is less than or equal to 1 mm. As another example, the second coil 134 is arranged on the side of the main control circuit board 13 that is toward the speaker 112, and the distance between the main control circuit board 13 and the speaker 112 in the winding axis direction of the first coil 1125 is less than or equal to 2 mm.

In the present disclosure, the core module 11 includes an element such as an inductor or a transceiver coil, which the inductor or the transceiver coil element may include the second coil 134. In some embodiments, the core module 11 includes a switching power supply. The switching power supply is configured to realize voltage conversion, and the switching power supply is arranged on the main control circuit board 13 and electrically connected to the main control circuit board 13. An inductance of the switching power supply may be the second coil 134, which is used to realize energy storage, filtering, or the like. In some embodiments, the core module 11 includes a communication device. The communication device is configured to realize that the earphone 10 is used in conjunction with a terminal device such as a cell phone, a computer, or the like. The communication device is arranged on the main control circuit board 13 and is electrically connected to the main control circuit board 13. The communication device includes a transceiver coil configured to transmit and receive a signal, and the transceiver coil of the communication device may be the second coil 134.

For example, in conjunction with FIG. 26 and FIG. 7, the main control circuit board 13 includes the substrate 135, metal wires 136 formed on the substrate 135, and a load 137 arranged on the substrate 135. The substrate 135 may be electrically insulating, the metal wires 136 may be printed on the substrate 135 through techniques such as copper etching, and the load 137 may be soldered to the substrate 135 through techniques such as surface mounting and connected to the metal wires 136. The main control circuit board 13 may use any one of a single panel, a double-layer panel, or a multi-layer panel, as desired. The metal wires 136 includes a power source wire 1361 and a loop wire 1362 that are configured to connect the load 137 to an external power source, such as the battery 14. The power source wire 1361 and the loop wire 1362 are arranged side-by-side, and a current direction of the power source wire 1361 is opposite to a current direction of the loop wire 1362 to allow a circuit loop to be formed between the load 137 and the external power source. Further, a ratio of an absolute value of a difference between a width of the power source wire 1361 or the loop wire 1362 and an average width to the average width is less than or equal to 20%, preferably, the ratio may be smaller than or equal to 15%, or preferably, the ratio may be smaller than or equal to 10%. The average width is defined as an average value of widths of the power source wire 1361 and the loop wire 1362. In short, the ratio may be used to measure the extent to which the width of either of the power source wire 1361 and the loop wire 1362 deviates from the average width. Thus, the smaller the ratio is, the closer the width of the power source wire 1361 and the width of the loop wire 1362 are. Set up in this way, since the current direction of the power source wire 1361 is opposite to the current direction of the loop wire 1362, so that a magnetic field generated by the power source wire 1361 and a magnetic field generated by the loop wire 1362 can cancel each other out when their vectors are superimposed in three-dimensional space. Since a difference between the width of the power source wire 1361 and the width of the loop wire 1362 is small, the magnetic field generated by the power source wire 1361 and the magnetic field generated by the loop wire1362 have a smaller total magnetic field strength when their vectors are superimposed in three-dimensional space, thereby reducing the electromagnetic interference from the metal wires 136 on the main control circuit board 13 to other electronic components, such as minimizing the risk of noise like 'hissing' or 'squealing' in the speaker 112 caused by the magnetic field generated by the metal wires 136 on the main control circuit board 13.

In some embodiments, an extension direction of the power source wire 1361 and an extension direction of the loop wire 1362 are arranged in parallel, facilitating the magnetic field generated by the power source wire 1361 and the magnetic field generated by the loop wire 1362 to cancel each other out. A thickness of the power source wire 1361 and a thickness of the loop wire 1362 may be equal, which is conducive to simplifying a molding process of the metal wires 136. A width of the power source wire 1361 and a width of the loop wire 1362 may be equal, which is conducive to the magnetic field generated by the power source wire 1361 and the magnetic field generated by the loop wire 1362 to cancel each other out. Furthermore, a length of the power source wire 1361 and a length of the loop wire 1362 may be equal, facilitating the magnetic field generated by the power source wire 1361 and the magnetic field generated by the loop wire 1362 to cancel each other out. It should be noted that: the thickness of the loop wire 1362 refers to its dimension in the thickness direction of the main control circuit board 13 (e.g., parallel to the thickness direction X).

In some embodiments, the power source wire 1361 and the loop wire 1362 are arranged on a same layer of the substrate 135.

In some embodiments, the power source wire 1361 and the loop wire 1362 are arranged on different layers of the substrate 135, and orthographic projections of the power source wire 1361 and the loop wire 1362 in the thickness direction of the main control circuit board 13 at least partially overlap.

In some embodiments, the load 137 is a component such as a main control chip or a communication chip.

In some embodiments, the main control circuit board 13 includes a connector 138. The connector 138 is arranged on the substrate 135 through techniques such as surface mounting. One end of the power source wire 1361 and the loop wire 1362 are each connected to the connector 138, respectively, and the other end of the power source wire 1361 and the loop wire 1362 are each connected to the load 137, respectively, so as to facilitate a connection between the load 137 and the external power source. For example, the battery 14 is configured as an external power source, and the battery 14 is connected to one end of the flexible circuit board 16 through the conductor 129, and the other end of the flexible circuit board 16 is snapped to the connector 138, which in turn allows the battery 14 to be connected to the main control circuit board 13.

The specific embodiments documented in the present disclosure are merely exemplary, and one or more of the technical features in the specific embodiments are optional or additional, and are not the necessary technical features constituting the inventive conception of the present disclosure. In other words, the scope of protection of the present disclosure encompasses and is much larger than the specific embodiments. And, the specific embodiments documented herein are merely exemplary, and are not intended to limit the scope of protection of the present disclosure, and any equivalent device or equivalent process transformations utilizing the contents of the present disclosure and the accompanying drawings, or applying directly or indirectly utilized in other related technical fields, are similarly included in the protection scope of the present disclosure.

## Claims

1. A core module, comprising:
a core shell; and
a speaker and a main control circuit board arranged in the core shell, wherein
the speaker includes a first coil coupled to the main control circuit board, a second coil is arranged on the main control circuit board, and a winding axis direction of the second coil crosses a winding axis direction of the first coil.

2. The core module of claim 1, wherein the main control circuit board and the speaker are stacked in the winding axis direction of the first coil.

3. The core module of claim 2, wherein the winding axis direction of the second coil is orthogonal to the winding axis direction of the first coil.

4. The core module of claim 3, wherein a distance between the main control circuit board and the speaker in the winding axis direction of the first coil is less than or equal to 3 mm.

5. The core module of claim 1, wherein
the core module comprises an inductor of a switching power supply, the inductor being arranged on the main control circuit board, and the inductor including the second coil; and/or
the core module comprises a transceiver coil of a communication device, the transceiver coil being arranged on the main control circuit board, and the transceiver coil including the second coil.

6. An earphone, comprising a hook structure and the core module of any one of claims 1 to 5, wherein
the hook structure is connected to the core shell, the core module is located at a front side of an ear in a wearing state, and at least a portion of the hook structure is located at a rear side of the ear in the wearing state.

7. The earphone of claim 6, wherein
the hook structure includes an adapter shell connected to the core shell,
least a portion of the adapter shell is located at the front side of the ear in the wearing state,
the adapter shell forms an accommodation cavity, the earphone comprising an electronic element and a flexible circuit board, wherein the electronic element is arranged in the accommodation cavity, the flexible circuit board is connected to the electronic element and extends into the core shell, which allows the electronic element to be connected to the main control circuit board through the flexible circuit board,
the first coil is arranged on an extension path of the flexible circuit board and connected to the flexible circuit board, and
the speaker is connected to the main control circuit board through the flexible circuit board.

8. The earphone of claim 7, wherein
the adapter shell forms a through hole in communication with the accommodation cavity,
the electronic element includes an electrode terminal at least partially arranged in the through hole, the electrode terminal including a charging positive terminal and a charging negative terminal that are arranged at intervals from each other, the charging positive terminal and the charging negative terminal being respectively arranged in a corresponding through hole.

9. The earphone of claim 7, wherein the core shell includes a core inner shell and a core outer shell covering the core inner shell, the core inner shell is closer to the ear than the core outer shell in the wearing state, and at least one of the core inner shell or the core outer shell is inserted and fixed to the adapter shell.

10. The earphone of claim 7, wherein the core shell includes a core inner shell and a core outer shell covering the core inner shell, the core inner shell is closer to the ear than the core outer shell in the wearing state, and at least one of the core inner shell or the core outer shell is arranged to be an integrated molded structure with the adapter shell.
